(19) **Europäisches Patentamt**
**European Patent Office**
**Office européen des brevets**

(11) **EP 2 049 910 B1**

(12) **EUROPÄISCHE PATENTSCHRIFT**

(45) Veröffentlichungstag und Bekanntmachung des Hinweises auf die Patenterteilung:
**30.12.2009 Patentblatt 2009/53**

(21) Anmeldenummer: **07764888.9**

(22) Anmeldetag: **27.06.2007**

(51) Int Cl.:
*G01R 33/02* (2006.01)  *G01R 33/07* (2006.01)

(86) Internationale Anmeldenummer:
**PCT/EP2007/005690**

(87) Internationale Veröffentlichungsnummer:
**WO 2008/017348 (14.02.2008 Gazette 2008/07)**

(54) **IM MESSBETRIEB KALIBRIERBARER MAGNETISCHER 3D-PUNKTSENSOR**

MAGNETIC 3D POINT SENSOR CAPABLE OF BEING CALIBRATED DURING MEASUREMENT OPERATION

CAPTEUR PONCTUEL TRIDIMENSIONNEL MAGNÉTIQUE POUVANT ÊTRE CALIBRÉ EN FONCTIONNEMENT DE MESURE

(84) Benannte Vertragsstaaten:
**FR GB IT SE**

(30) Priorität: **09.08.2006 DE 102006037226**

(43) Veröffentlichungstag der Anmeldung:
**22.04.2009 Patentblatt 2009/17**

(73) Patentinhaber: **Fraunhofer-Gesellschaft zur Förderung der angewandten Forschung e.V.
80686 München (DE)**

(72) Erfinder:
• **HOHE, Hans-Peter
91332 Heiligenstadt (DE)**
• **HACKNER, Michael
92331 Parsberg (DE)**
• **STAHL-OFFERGELD, Markus
91058 Erlangen (DE)**

(74) Vertreter: **Hersina, Günter Siegfried et al
Schoppe, Zimmermann, Stoeckeler & Zinkler
Postfach 246
82043 Pullach (DE)**

(56) Entgegenhaltungen:
**EP-A- 1 637 898    WO-A-01/18556**

• **DRAGANA R POPOVIC ET AL: "Three-Axis Teslameter with Integrated Hall Probe Free from the Planar Hall Effect" INSTRUMENTATION AND MEASUREMENT TECHNOLOGY CONFERENCE, 2006. IMTC 2006. PROCEEDINGS OF THE IEEE, IEEE, PI, April 2006 (2006-04), Seiten 1812-1815, XP031057005 ISBN: 0-7803-9359-7**
• **DATABASE INSPEC [Online] THE INSTITUTION OF ELECTRICAL ENGINEERS, STEVENAGE, GB; 15. Mai 2000 (2000-05-15), SCHOTT C ET AL: "Single-chip 3-D silicon Hall sensor" XP002465468 Database accession no. 6602820 & TRANSDUCERS '99: 10TH INTERNATIONAL CONFERENCE ON SOLID STATE SENSORS AND ACTUATORS 7-10 JUNE 1999 SENDAI, JAPAN, Bd. A82, Nr. 1-3, 15. Mai 2000 (2000-05-15), - 15. Mai 2000 (2000-05-15) Seiten 167-173, Sensors and Actuators A (Physical) Elsevier Switzerland ISSN: 0924-4247**

**Beschreibung**

Die vorliegende Erfindung bezieht sich auf Hall-Sensoren zur Erfassung von räumlichen Komponenten eines Magnetfeldes in einem Referenzpunkt, sowie auf die dort eingesetzten Kalibrierungs- und Messverfahren.

Auf dem Hall-Effekt basierende Hall-Sensorelemente werden in der Technik neben der Vermessung von Magnetfeldern nach Betrag und Richtung, häufig auch für kontaktfreie, berührungslose Signalgeber zur verschleißfreien Erfassung der Stellung von Schaltern oder Stellgliedern eingesetzt. Eine weitere Einsatzmöglichkeit besteht in der Strommessung, wobei ein Hall-Sensorelement in der Nähe einer Leiterbahn angeordnet wird und den Strom in der Leiterbahn über die Erfassung des durch den Strom in der Leiterbahn erzeugten Magnetfeldes kontaktlos bemisst. In der praktischen Anwendung haben sich Hall-Sensorelemente insbesondere durch ihre relativ starke Unempfindlichkeit gegenüber äußeren Einflüssen, wie z. B. Verschmutzungen und so weiter, ausgezeichnet.

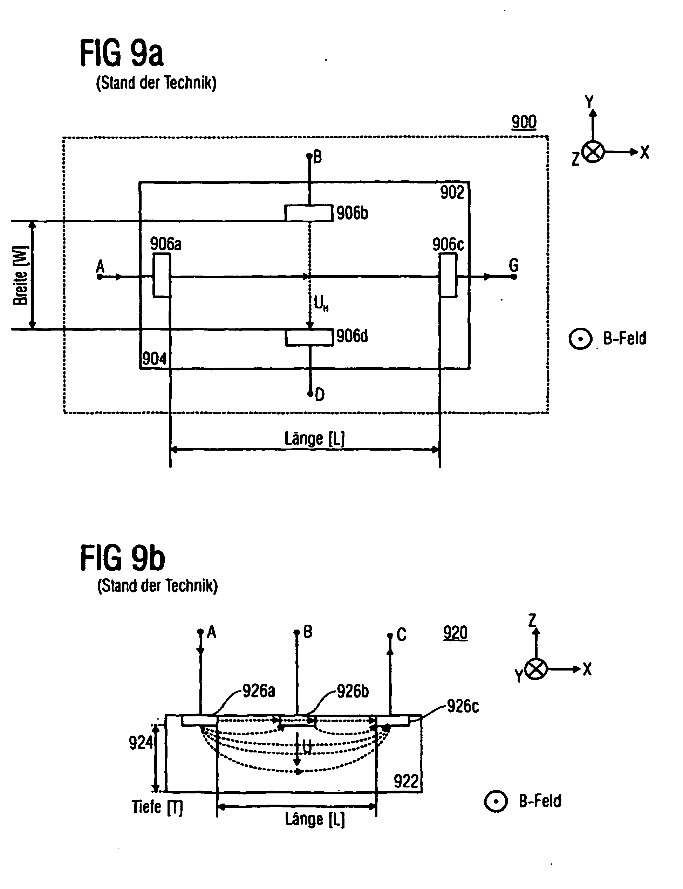

In der Technik sind sowohl sogenannte horizontale oder laterale Hall-Sensorelemente als auch vertikale Hall-Sensorelemente bekannt, wobei in Fig. 9a ein horizontales Hall-Sensorelement und in Fig. 9b ein vertikales Hall-Sensorelement gemäß dem Stand der Technik beispielhaft dargestellt sind.

Ein Hall-Sensorelement ist im Allgemeinen aus einem Halbleiterplättchen mit vier Kontaktanschlüssen, die zur elektrischen Verbindung mit einer externen Ansteuerschaltung vorgesehen sind, aufgebaut. Von den vier Kontaktanschlüssen eines Hall-Sensorelementes sind zwei Kontaktanschlüsse zur Betriebsstromeinprägung durch einen aktiven Halbleiterbereich vorgesehen, während die anderen beiden Kontaktanschlüsse vorgesehen sind, um die Hall-Spannung zu erfassen. Setzt man das von dem Betriebsstrom durchflossene Halbleiterplättchen einem Magnetfeld mit der Induktion $\overline{B}$ aus, so kommt es zu einer Ablenkung der Strombahnen, die durch die auf die bewegten Ladungsträger im magnetischen Feld einwirkende "Lorenz-Kraft" verursacht wird. Die Hall-Spannung ergibt sich senkrecht zur Richtung des Stromflusses und senkrecht zum anliegenden Magnetfeld in dem aktiven Halbleitergebiet.

Wie nun in Fig. 9a prinzipiell dargestellt ist, ist ein horizontales Hall-Sensorelement 900 gemäß dem Stand der Technik im Allgemeinen aus einem n-dotierten Halbleiterbereich 902 auf einem p-dotierten Halbleitersubstrat 904 aufgebaut. Als horizontal wird ein Hall-Sensorelement bezeichnet, das parallel zu einer Chipoberfläche (x-y-Ebene) angeordnet ist.

Der n-dotierte aktive Bereich 902 ist üblicherweise über vier Kontaktelektroden 906a-d, die jeweils paarweise gegenüberliegend in dem aktiven Bereich 902 angeordnet sind, mit einer externen Ansteuer- bzw. Auswertelogik verbunden. Die Ansteuer- bzw. Auswertelogik ist der Übersichtlichkeit halber in Fig. 9 nicht dargestellt. Die vier Kontaktelektroden 906a-d unterteilen sich in zwei gegenüberliegende Steuerstromkontaktelektroden 906a und 906c, die vorgesehen sind, um einen Stromfluss $I_H$ durch den aktiven Bereich 902 zu erzeugen, und ferner in zwei gegenüberliegende Spannungsabgriffskontaktelektroden 906b und 906d, die vorgesehen sind, um eine Hall-Spannung $U_H$, die bei einem anliegenden Magnetfeld $\overline{B}$ senkrecht zu dem Stromfluss in dem aktiven Bereich 902 und dem anliegenden Magnetfeld auftritt, als Sensorsignal abzugreifen. Indem nun der Stromfluss $I_H$ zwischen verschiedenen Kontaktelektroden eingeprägt und entsprechend die Hall-Spannung $U_H$ an den anderen Kontaktelektroden senkrecht zum Stromfluss abgegriffen wird, lassen sich Kompensationsverfahren implementieren, die es ermöglichen, Toleranzen, die in den Hall-Sensoren beispielweise aufgrund von Herstellungstoleranzen usw. auftreten, über mehrere Messzyklen zu kompensieren.

Wie aus dem in Fig. 9a dargestellten horizontalen Hall-Sensorelement 900 ersichtlich ist, ist der aktive Bereich zwischen den Kontaktanschlüssen 906a-d definiert, so dass der aktive Bereich eine effektive Länge L und eine effektive Breite W aufweist. Die anhand von Fig. 9a dargestellten horizontalen Hall-Sensorelemente 900 sind relativ einfach mit herkömmlichen CMOS-Prozessen (CMOS = Complementary Metal Oxide Semiconductor) zur Herstellung von Halbleiterstrukturen herstellbar.

Neben den horizontalen Hall-Sensorelementen sind im Stand der Technik ferner Realisierungen sogenannter vertikaler Hall-Sensoranordnungen bekannt, die auch den Einsatz von Standard-Halbleiterherstellungstechnologien, beispielsweise von CMOS-Prozessen, ermöglichen. Ein Beispiel für ein vertikales Hall-Sensorelement 920 ist prinzipiell in Fig. 9b dargestellt, wobei mit vertikal eine Ebene senkrecht zur Ebene der Chipoberfläche (X-Y-Ebene) gemeint ist. Bei dem in Fig. 9b dargestellten vertikalen Hall-Sensorelement 920 erstreckt der sich vorzugsweise n-dotierte aktive Halbleiterbereich 922 in Form einer Wanne in einem p-dotierten Halbleitersubstrat 924, wobei der aktive Halbleiterbereich 922 eine Tiefe T aufweist. Wie nun in Fig. 9b dargestellt ist, weist das vertikale Hall-Sensorelement drei Kontaktbereiche 926a-c auf, die angrenzend an die Hauptoberfläche des Halbleitersubstrats 924 in demselben angeordnet sind, wobei sich die Kontaktanschlüsse 926a-c alle in dem aktiven Halbleiterbereich 922 befinden. Aufgrund der drei Kontaktbereiche wird diese Variante von vertikalen Hall-Sensorelementen auch 3-Pin-Sensor genannt.

Das in Fig. 9b dargestellte vertikale Hall-Sensorelement 920 weist also drei Kontaktbereiche 926a-c entlang der Hauptoberfläche des aktiven Halbleiterbereichs 922 auf, wobei der Kontaktbereich 926a mit einem Kontaktanschluss A verbunden ist, der Kontaktbereich 926b mit einem Kontaktanschluss B verbunden ist und wobei der Kontaktbereich 926c mit einem Kontaktanschluss C verbunden ist. Wird nun zwischen die beiden Kontaktanschlüsse A und C eine Spannung angelegt, so stellt sich ein Stromfluss $I_H$ durch den aktiven Halbleiterbereich 922 ein, und am Kontaktanschluss B kann nun eine Hall-Spannung $U_H$, die senkrecht zum Stromfluss $I_H$ und zum Magnetfeld $\overline{B}$ ausgerichtet ist, gemessen werden. Die effektiv wirksamen Bereiche des aktiven Halbleiterbereichs 922 sind durch die Tiefe T des aktiven Halbleiterbereichs 922 und die Länge L entsprechend dem Abstand zwischen den Stromeinspeisungskontaktelektroden 926a und 926c vorgegeben.

Horizontale und vertikale Hall-Sensoren, sowie die Verfahren zur Reduzierung von Offsets, die durch Bauelementtoleranzen wie beispielsweise Verunreinigungen, Asymmetrien, piezoelektrische Effekte, Alterungserscheinungen usw. entstehen, beispielsweise mit dem Spinning-Current-Verfahren, sind in der Literatur bereits bekannt, z. B. R. S. Popovic, "Hall Effect Devices, Magnetic Sensors and Characterization of Semiconductors", Adam Hilger, 1991, ISBN 0-7503-0096-5. Häufig bestehen vertikale Sensoren, die Spinning-Current betrieben werden, aus zwei, oder aus vier Einzelsensoren, wie dies beispielsweise die DE 101 50 955 und DE 101 50 950 beschreiben.

Ferner gibt es neben der Variante der 3-pinnigen vertikalen Hall-Sensorelemente auch sogenannte 5-pinninge vertikale Hall-Sensorelemente, die ebenfalls in DE 101 50 955 und DE 101 50 950 beschrieben werden. Auch bei den 5-Pin-Hall-Sensorelementen besteht die Möglichkeit mittels eines Kompensationsverfahrens, das sich über mehrere Messphasen erstreckt, eine um Toleranzen der einzelnen Bauteile kompensierte Messung durchzuführen, beispielsweise könnte auch hier ein Spinning-Current-Verfahren eingesetzt werden.

Die Spinning-Current-Technik besteht nun darin, die Messrichtung zur Erfassung der Hall-Spannung an dem Hall-Sensorelement ständig mit einer bestimmten Taktfrequenz um beispielsweise 90° zyklisch weiter zu drehen und über alle Messsignale einer vollen Drehung um 360° aufzusummieren. Bei einem Hall-Sensorelement mit vier Kontaktbereichen, von denen jeweils zwei Kontaktbereiche paarweise zueinander zugeordnet sind, wird daher jedes der Kontaktpaare je nach Spinning-Current-Phase sowohl als Steuerstromkontaktbereiche zur Stromeinspeisung als auch als Messkontaktbereiche zum Abgreifen des Hall-Signals genutzt. So fließt in einer Spinning-Current-Phase bzw. in einem Spinning-Current-Zyklus der Betriebsstrom (Steuerstrom $I_H$) zwischen zwei zugeordneten Kontaktbereichen, wobei die Hall-Spannung an den beiden anderen einander zugeordneten Kontaktbereichen abgegriffen wird.

Beim nächsten Zyklus wird dann die Messrichtung um 90° weitergedreht, so dass die Kontaktbereiche, die im vorangehenden Zyklus zum Abgreifen der Hall-Spannung eingesetzt wurden, nunmehr zur Einspeisung des Steuerstroms dienen. Durch die Summation über alle vier Zyklen bzw. Phasen heben sich herstellungs- oder materialbedingte Offset-Spannungen annähernd gegenseitig auf, so dass nur die tatsächlich magnetfeldabhängigen Anteile des Signals übrig bleiben. Diese Vorgehensweise ist natürlich auch auf eine größere Anzahl von Kontaktpaaren anwendbar, wobei beispielsweise bei vier Kontaktpaaren (mit acht Kontaktbereichen) die Spinning-Current-Phasen um 45° zyklisch weiter gedreht werden, um alle Messsignale über einer vollen Drehung um 360° aufsummieren zu können.

Bei horizontalen Hall-Sensoren werden ebenfalls häufig vier Sensoren verwendet, da bei geeigneter Anordnung der Offset durch räumlichen Spinning-Current-Betrieb zusätzlich stark reduziert werden kann, siehe z.B. DE 199 43 128.

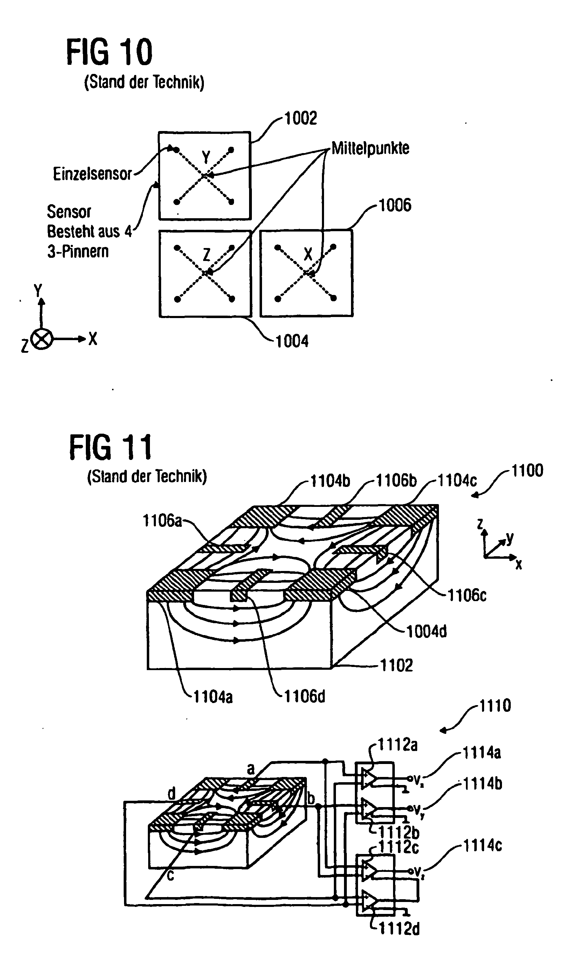

Soll ein Magnetfeld für mehrere Raumrichtungen gemessen werden, so werden hierzu zumeist getrennte Hall-Sensorelemente verwendet. Die Verwendung getrennter Sensoren, beispielsweise zur Erfassung der drei Raumrichtungen eines Magnetfeldes, bringt generell die Problematik mit sich, dass das zu vermessende Magnetfeld nicht in einem Punkt, sondern in drei verschiedenen Punkten gemessen wird. Fig. 10 verdeutlicht diesen Aspekt, wobei Fig. 10 drei Hall-Sensoren 1002, 1004 und 1006 zeigt. Der erste Hall-Sensor 1002 ist zur Erfassung einer y-Raumkomponente, der zweite Hall-Sensor 1004 ist zur Erfassung einer z-Raumkomponente und der dritte Hall-Sensor 1006 ist zur Erfassung einer x-Raumkomponente vorgesehen. Die Einzelsensoren 1002, 1004 und 1006 messen dabei die entsprechenden Raumkomponenten eines Magnetfeldes näherungsweise in den jeweiligen Mittelpunkten der Einzelsensoren.

Ein Einzelsensor kann wiederum aus mehreren Hall-Sensorelementen aufgebaut sein. Fig. 10 zeigt beispielhaft drei Einzelsensoren, die jeweils vier Hall-Sensorelemente aufweisen, wobei in Fig. 10 beispielhaft von einem horizontalen Hallsensor 1004 ausgegangen wird, der eine z-Komponente des zu messenden Magnetfeldes erfasst, und von je einem vertikalen Hallsensor 1002 und 1006 für y- bzw. x-Komponente des zu messenden Magnetfeldes. Die Anordnung zur Erfassung der räumlichen Magnetfeldkomponenten, wie beispielhaft in Fig. 10 dargestellt, weist die Problematik auf, dass das Magnetfeld nicht in einem Punkt gemessen werden kann, sondern in den jeweiligen Mittelpunkten der Einzelsensoren. Dies bringt zwangsläufig eine Verfälschung mit sich, da keine exakte Auswertung des Magnetfeldes basierend auf den an unterschiedlichen Orten erfassten Magnetfeldkomponenten des Magnetfeldsensors möglich ist.

Ein weiterer Aspekt bei der Erfassung und Auswertung von Magnetfeldern mittels Hall-Sensorelementen ist die Kalibrierung der Einzelelemente. Gemäß dem Stand der Technik werden Hall-Sensorelemente zumeist mit sogenannten Erregerleitungen versehen, die es erlauben, ein definiertes Magnetfeld im Messpunkt eines Einzelsensors zu erzeugen, um anschließend durch Vergleich bzw. Zuordnung der gemessenen Hall-Spannung zu dem definierten Magnetfeld eine Kalibrierung des Sensors zu erreichen.

Mit Erregerleitern ist es möglich ein künstliches Magnetfeld an einem Hall-Sensor zu erzeugen, mit dem ein einfacher Wafertest, d.h. ein Test direkt auf dem Substrat, sowie ein Selbsttest und eine Empfindlichkeitskalibrierung im laufenden Betrieb möglich ist, vergleiche Janez Trontelj, "Optimization of Integrated Magnetic Sensor by Mixed Signal Processing, Proceedings of the 16th IEEE Vol. 1. Dies ist in sicherheitskritischen Bereichen, z. B. im Automobilbereich oder auch in der Medizintechnik, von besonderem Interesse, da hiermit eine Selbstüberwachung der Sensoren auch im Betrieb möglich wird.

Werden nun beispielsweise zur Erfassung der räumlichen Komponenten eines Magnetfeldes mehrere Einzelsensoren, wie beispielhaft in Fig. 10 gezeigt, verwendet, so benötigt jeder Einzelsensor eine entsprechende Erregerleitung zur Kalibrierung, und die Einzelsensoren werden weiterhin einzeln kalibriert. Der Kalibrierungsaufwand skaliert also mit der Anzahl von Einzelsensorelementen und erhöht sich also im Falle der räumlichen Erfassung von drei Magnetfeldkomponenten um das Dreifache gegenüber dem Kalibrierungsaufwand eines Einzelsensors.

Ein Ansatz, um eine Auswertung eines Magnetfeldes zu ermöglichen, d.h. eine Messung in einem Punkt zu erfassen, ist ein 3D-Sensor der Ecole Polytechnique Federal Lausanne EPFL, vergleiche C. Schott, R. S. Popovic, "Integrated 3D Hall Magnetic Field Sensor", Transducers '99, June 7-10, Sensai, Japan, VOL. 1, PP. 168-171, 1999. Fig. 11 zeigt schematisch einen solchen Hall-Sensor 1100, der auf ein Halbleitersubstrat 1102 implementiert ist. Der 3D-Sensor weist zunächst vier Kontaktflächen 1104a-d auf, über die Ströme in das Halbleitersubstrat 1102 eingeprägt werden können. Der 3D-Sensor weist ferner vier Messkontaktflächen 1106a-d auf, über die die verschiedenen Magnetfeldkomponenten erfasst werden können. In Fig. 11 ist auf der rechten Seite eine Verschaltung 1110 dargestellt. Die gezeigte Verschaltung, die sich aus vier Operationsverstärkern 1112a-d zusammensetzt, wertet die zu den einzelnen Magnetfeldkomponenten proportionalen Hall-Spannungen aus, und gibt die entsprechenden Komponenten an den Anschlüssen 1114a-c, in Form der Signale Vx, Vy und Vz aus.

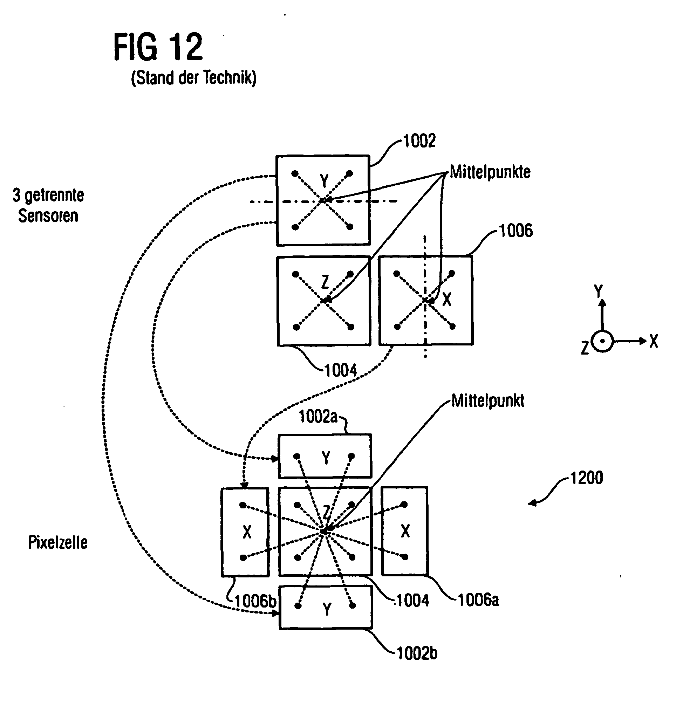

Der dargestellte Sensor bringt die Problematik mit sich, dass er nur durch ein definiertes von außen erzeugtes Magnetfeld kalibriert werden kann und keine eigene Erregerleitung aufweist. Ferner kann dieser Sensor aufgrund seines Aufbaus und seiner Funktionsweise nicht mit einem Kompensationsverfahren, z.B. Spinning-Current-Verfahren betrieben werden. Weiterhin besteht ein Problem in der in Fig. 11 gezeigten Anordnung darin, dass ein solcher Halbleiter-Baustein aufgrund von Verunreinigungen des Halbleitermaterials, Asymmetrien in der Kontaktierung, Varianzen in der Kristallstruktur usw. Offset-Spannungen aufweist, die nicht über eine entsprechende Spinning-Current-taugliche Kompensationsverschaltung unterdrückt werden können. Der Sensor misst somit zwar Magnetfeldkomponenten in einem fokussierten Punkt, besitzt aber einen hohen Offset und ist daher nur eingeschränkt für präzise Messungen geeignet. Fig. 12 zeigt einen kompensationsfähigen (Spinning-Current) 3D-Sensor, der räumliche Magnetfeldkomponenten in einem Messpunkt erfasst und von Enrico Schurig in "Highly Sensitive Vertical Hall Sensors in CMOS Technology", Hartung-Gorre Verlag Konstanz, 2005, Reprinted from EPFL Thesis N° 3134 (2004), ISSN 1438-0609, ISBN 3-86628-023-8 WW. 185ff erörtert wird. In Fig. 12 oben ist zunächst der aus den drei Einzelsensoren bestehende 3D-Sensor aus Fig. 10 gezeigt. Fig. 12 zeigt im oberen Teil die drei getrennten Einzelsensoren 1002, 1004 und 1006 zur Erfassung der räumlichen Magnetfeldkomponenten. In Fig. 12 ist im unteren Teil eine alternative Anordnung der Einzelsensoren gezeigt. Bei dieser Anordnung wird der Sensor 1004 unverändert beibehalten, da der Messpunkt des Sensors 1004 in der Mitte der Anordnung 1200 in Fig. 12 liegt, ferner bestehen die beiden Einzelsensoren 1002 und 1006 aus Einzelelementen, die trennbar sind. Der Sensor 1002 wird also jetzt in zwei Sensorteile 1202a und 1202b aufgeteilt und symmetrisch um den Mittelpunkt des Sensorelements 1004 angeordnet. Eine analoge Verfahrensweise wird dem Sensor 1006 zuteil, so dass auch dieses in zwei Sensorteile 1206a und 1206b aufgeteilt wird, die symmetrisch um den Mittelpunkt des Sensorelements 1004 angeordnet sind, entlang der entsprechenden Raumachse. Durch die symmetrische Anordnung der einzelnen Sensorelemente wird nun das magnetische Feld in einem Punkt erfasst, der im geometrischen Zentrum der Anordnung liegt. Ein Nachteil dieser Anordnung ist, dass dieser Sensor nur Ober mehrere Erregerleiter kalibriert werden kann. Die Anordnung in Fig. 12 unten 1200 wird im Folgenden auch als Pixelzelle ohne Kalibrierung bezeichnet.

Dragana R. Popovic et al. beschreibt in "Three-Axis Teslameter with Integrated Hall Probe Free from the Planar Hall Effect" einen dreidimensionalen Hall-Sensor, der in einen Halbleiterchip integriert ist. Ferner wird eine Beschaltung des Magnetfeldsensors beschrieben, die es erlaubt, Messtoleranzen, die beispielsweise durch Temperaturdrift hervorgerufen werden, zu kompensieren.

Die EP 1 637 898 A1 offenbart einen eindimensionalen Magnetfeldsensor, der über ein Referenzfeld kalibrierbar ist. Ein Referenzfeldgenerator generiert dabei ein magnetisches Wechselfeld, das sich in der Frequenz von einem Messfeld deutlich unterscheidet. Eine nachgeschaltete Signalverarbeitung erlaubt durch Trennung der Mess- bzw. Referenzfeldkomponenten im Frequenzbereich eine Kalibrierung des Sensors bzw. eine Kompensation von Temperatureffekten. Als Magnetfeldsensor wird hier ein horizontaler Magnetfeldsensor, ein sogenanntes Hall-Plättchen, verwendet.

Es ist die Aufgabe der vorliegenden Erfindung einen Magnetfeldsensor zur räumlichen Erfassung von Magnetfeldkomponenten in einem Referenzpunkt zu schaffen, dessen Toleranzen mittels Messungen in verschiedenen Betriebsphasen, vorzugsweise mittels Spinning-Current-Betrieb, effizient kompensierbar sind, der sowohl zuverlässig und unaufwendig kalibrierbar ist, wobei eine Kalibrierung im Messbetrieb durchführbar ist, und der aufwandgünstig und effizient sowohl in einem On-Wafer-Test als auch im Betrieb testbar ist.

Diese Aufgabe wird durch einen im Messbetrieb kalibrierbaren Magnetfeldsensor gemäß Anspruch 1 und ein Verfahren zum Kalibrieren eines Magnetfeldsensors im Messbetrieb gemäß Anspruch 8 gelöst.

Die vorliegende Erfindung schafft einen im Messbetrieb kalibrierbaren Magnetfeldsensor zur Erfassung einer ersten, zweiten und dritten räumlichen Komponente $B_z$, $B_y$ und $B_x$ eines Magnetfeldes in einem Referenzpunkt, wobei das Magnetfeld eine erste, zweite und dritte Messfeldkomponente $B_{Mz}$, $B_{My}$ und $B_{Mx}$ und eine erste, zweite und dritte Kalibrierungsfeldkomponente $B_{Kz}$, $B_{Ky}$ und $B_{Kx}$ aufweist, mit einer ersten Sensorelementanordnung zur Erfassung der ersten Magnetfeldkomponente $B_z$, die eine erste Messfeldkomponente $B_{Mz}$ und eine erste Kalibrierungsfeldkomponente $B_{Kz}$ aufweist, bezüglich einer ersten Raumachse z im Referenzpunkt. Der Magnetfeldsensor umfasst ferner eine zweite Sensorelementanordnung zur Erfassung der zweiten Magnetfeldkomponente $B_y$, die eine zweite Messfeldkomponente $B_{My}$ und eine zweite Kalibrierungsfeldkomponente $B_{Ky}$ aufweist, bezüglich einer zweiten Raumachse y im Referenzpunkt und einer dritten Sensorelementanordnung zur Erfassung der dritten Magnetfeldkomponente $B_x$, die eine dritte Messfeld-komponente $B_{Mx}$ und eine dritte Kalibrierungsfeldkomponente $B_{Kx}$ aufweist, bezüglich einer dritten Raumachse x im Referenzpunkt. Der Magnetfeldsensor weist ferner eine Erregerleitung auf, die so bezüglich der ersten, zweiten und dritten Sensorelementanordnung angeordnet ist, dass bei einer Einprägung eines vorgegebenen Stroms in die Erregerleitung eine erste vorgegebene Kalibrierungsfeldkomponente $B_{Kz}$ bezüglich der ersten Raumachse z in der ersten Sensorelementanordnung erzeugt wird, eine zweite vorgegebene Kalibrierungsfeldkomponente $B_{Ky}$ bezüglich der zweiten Raumachse y in der zweiten Sensorelementanordnung erzeugt wird und eine dritte vorgegebene Kalibrierungsfeldkomponente $B_{Kx}$ bezüglich der dritten Raumachse x in der dritten Sensorelementanordnung erzeugt wird, wobei die drei Raumachsen z, y und x entlang linear unabhängiger Ortsvektoren verlaufen.

Die Aufgabe wird ferner gelöst durch ein Verfahren zum Kalibrieren eines Magnetfeldsensors im Messbetrieb mittels Erfassung einer ersten, zweiten und dritten räumlichen Komponente $B_z$, $B_y$ und $B_x$ eines Magnetfeldes in einem Referenzpunkt, wobei das Magnetfeld eine erste, zweite und dritte Messfeldkomponente $B_{Mz}$, $B_{My}$ und $B_{Mx}$ und eine erste, zweite und dritte Kalibrierungsfeldkomponente $B_{Kz}$, $B_{Ky}$ und $B_{Kx}$ aufweist, mit einem Schritt des Erfassens der ersten Magnetfeldkomponente $B_z$, die eine erste Messfeldkomponente $B_{Mz}$ und eine erste Kalibrierungsfeldkomponente $B_{Kz}$ aufweist, bezüglich der ersten Raumachse z im Referenzpunkt und durch Erfassen der zweiten Magnetfeldkomponente $B_y$, die eine zweite Messfeldkomponente $B_{My}$ und eine zweite Kalibrierungsfeldkomponente $B_{Ky}$ aufweist, bezüglich der zweiten Raumachse y im Referenzpunkt. Das Verfahren umfasst ferner einen Schritt des Erfassens der dritten Magnetfeldkomponente $B_x$, die eine dritte Messfeldkomponente $B_{Mx}$ und eine dritte Kalibrierungsfeldkomponente $B_{Kx}$ aufweist, bezüglich der dritten Raumachse x im Referenzpunkt und einen Schritt des Erzeugens der ersten, zweiten und dritten Kalibrierungsfeldkomponente $B_{Kz}$, $B_{Ky}$ und $B_{Kx}$ bezüglich der ersten, zweiten und dritten Raumachse z, y und x, wobei die erste, zweite und dritte Raumachse entlang linear unabhängiger Ortsvektoren verlaufen.

Der vorliegenden Erfindung liegt die Erkenntnis zugrunde, dass durch eine räumliche, vorzugsweise paarweise symmetrische Anordnung verschiedener Magnetfeldsensoren, die die Komponenten eines Magnetfeldes in einem Punkt erfassen, und in einem Kompensationsverfahren, wie beispielsweise dem Spinning-Current-Verfahren betrieben werden können, sich die Möglichkeit bietet, durch Anlegen eines Kalibrierungsfeldes, das von einer einzigen Erregerleitung hervorgerufen werden kann, diese im Betrieb zu kalibrieren. Der erfindungsgemäße Magnetfeldsensor kann sich gleichzeitig in einem Messfeld und in einem Kalibrierungsfeld befinden und kann in einem aus mehreren Messphasen zusammengesetzten Messverfahren, vorzugsweise Spinning-Current, betrieben werden.

Eine erste Kombination der Messergebnisse aus den einzelnen Messphasen erlaubt dabei, eine Messkomponente zu extrahieren, die auf das zu messende Magnetfeld zurückgeht und in der sowohl Komponenten die auf das Kalibrierungsfeld zurückgehen als auch Komponenten die auf Bauteiltoleranzen zurückzuführen sind, im Wesentlichen eliminiert sind. Eine zweite Kombination der Messergebnisse aus den einzelnen Messphasen erlaubt ferner eine Messkomponente zu extrahieren, die auf das Kalibrierungsfeld zurückzuführen ist und Komponenten des zu messenden Magnetfeldes im Wesentlicheneliminiert sind.

Dabei bietet der erfindungsgemäße Magnetfeldsensor und das erfindungsgemäße Verfahren den Vorteil, dass unter Verwendung herkömmlicher Kompensationsverfahren, wie beispielsweise dem Spinning-Current-Verfahren keine zusätzlichen Messphasen zur Kalibrierung benötigt werden.

Eine Erregerleitung, die aufgrund ihrer Geometrie Kalibrierungsfeldkomponenten in allen Raumrichtungen erzeugt, wird dabei derart bestromt, d.h. das Kalibrierungsfeld wird derart ausgerichtet, dass die beiden Kombinationen der Messergebnisse aus den einzelnen Messphasen in der beschriebenen Art ermöglicht werden. Das Erzeugen und die Ausrichtung des Kalibrierungsfeldes wird somit an die Messphasen des Kompensationsverfahrens angepasst bzw. darin eingebunden. Dies bietet den Vorteil, dass die Anordnung mit einer einzigen Erregerleitung auskommt, womit der erfindungsgemäße Magnetfeldsensor einfache und unkomplizierte Testmöglichkeiten schafft. Beispielsweise können die Erregerleitungen mehrerer erfindungsgemäßer Magnetfeldsensoren kaskadiert und somit gemeinsam in einem On-Wafer-Test getestet werden.

Ein weiterer Vorteil des erfindungsgemäßen Magnetfeldsensors und Verfahrens liegt darin, dass der Magnetfeldsensor im Betrieb kalibriert werden kann und dazu kein zusätzlicher Hardware- oder Zeitaufwand notwendig ist. Beispielsweise können die Messergebnisse aus den einzelnen Messphasen von einem Mikrocontroller oder einem Prozessor kombiniert bzw. ausgewertet werden, so dass der zusätzliche Aufwand auf eine zusätzliche Rechenoperation beschränkt ist. Die Messfeldkomponenten und die Kalibrierungsfeldkomponenten können dabei jeweils gleichzeitig und kompensiert zur Verfügung gestellt werden. Dies ist gerade bei sicherheitskritischen Anwendungsfällen, wie beispielsweise in der Automobil- oder Medizintechnik äußerst vorteilhaft, da der Magnetfeldsensor kontinuierlich kalibriert bzw. justiert und gleichzeitig seine Funktionsfähigkeit überwacht werden kann, ohne dass dabei in vielen Fällen Kompromisse hinsichtlich der Qualität oder Quantität einer Messung eingegangen werden müssen.

Bevorzugte Ausführungsbeispiele der Erfindung werden nachfolgend unter Bezugnahme auf die beiliegenden Zeichnungen näher erläutert. Es zeigen:

Fig. 1      eine prinzipielle Anordnung von Hall- Sensorelementen gemäß einem Ausführungsbeispiel des im Messbetrieb kalibrierbaren Magnetfeldsen- sors gemäß der vorliegenden Erfindung;

Fig. 2      Schnittansicht mit prinzipiellen magnetischen Feldlinien zur Verdeutlichung des Kalibrierungs- verfahrens in dem Ausführungsbeispiel des erfin- dungsgemäßen Magnetfeldsensors;

Fig. 3      prinzipielle Anordnung von Hall-Sensorelementen gemäß einem weiteren erfindungsgemäßen Ausfüh- rungsbeispiel;

Fig. 4a-d      prinzipielle Verschaltungen und Ersatzschaltbil- der von Hall-Sensorelementen in einem Ausfüh- rungsbeispiel zur Verdeutlichung des erfindungs- gemäßen Kompensationsverfahrens;

Fig. 5      eine alternative Anordnung der Hall- Sensorelemente gemäß einem weiteren Ausführungsbeispiel des erfindungsgemäßen Magnetfeldsensors;

Fig. 6      prinzipielle Anordnung der Hall-Sensorelemente gemäß einem weiteren Ausführungsbeispiel, zur Verdeutlichung des Kalibrierungsverfahrens;

Fig. 7      prinzipielle Anordnung zur Verdeutlichung des Ka- librierungsverfahrens gemäß einem weiteren Aus- führungsbeispiel;

Fig. 8      ein Ausführungsbeispiel einer Anordnung von meh- reren Sensorelementen zur Erfassung einer räumli- chen Magnetfeldkomponente;

Fig. 9a      den prinzipiellen Aufbau eines horizontalen Hall- Sensorelementes gemäß dem Stand der Technik;

Fig. 9b      den prinzipiellen Aufbau eines vertikalen Hall- Sensorelementes gemäß dem Stand der Technik;

Fig. 10      prinzipielle Anordnung von Einzelsensoren zur räumlichen Erfassung von Magnetfeldkomponenten gemäß dem Stand der Technik;

Fig. 11      alternativer 3D-Sensor zur Erfassung räumlicher Komponenten eines Magnetfeldes gemäß dem Stand der Technik;

Fig. 12      prinzipielle Anordnung von Einzel-Hall- Sensorelementen zur Erfassung eines räumlichen Magnetfeldes in einem Punkt; und

Bezüglich der nachfolgenden Ausführungen sollte beachtet werden, dass in den unterschiedlichen Ausführungsbeispielen gleiche oder gleichwirkende Funktionselemente gleiche Bezugszeichen aufweisen und somit in den verschiedenen, im den nachfolgenden dargestellten Ausführungsbeispielen untereinander austauschbar sind.

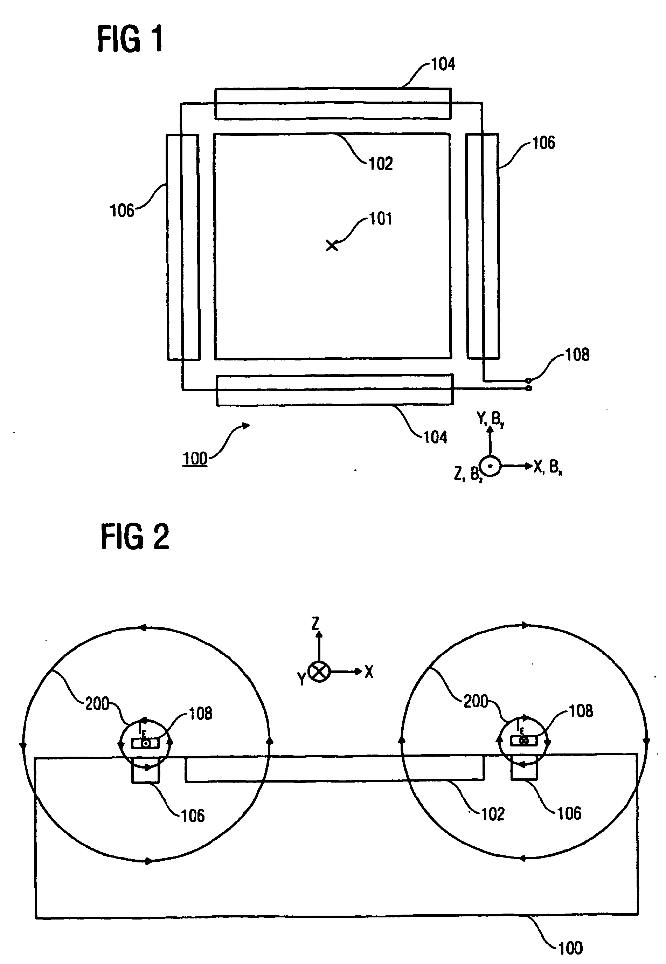

Bezugnehmend auf Fig. 1 wird nun der erfindungsgemäße Aufbau eines im Betrieb kalibrierbaren Magnetfeldsensors 100 gemäß einem ersten Ausführungsbeispiel erläutert. Fig. 1 zeigt ein Ausführungsbeispiel eines erfindungs- gemäßen Magnetfeldsensors 100, zur Erfassung eines Magnetfeldes in einem Referenzpunkt 101. Ferner zeigt Fig. 1 eine erste Sensorelementanordnung 102, eine zweite Sensorelementanordnung 104 und eine dritte Sensorelementanordnung 106. Weiterhin ist in Fig. 1 ist eine Erregerleitung 108 dargestellt.

Beispielsweise kann der Magnetfeldsensor auf einem Substrat implementiert sein, dessen Hauptoberfläche parallel zur x-y-Ebene der Anordnung verläuft, wobei die z-Komponente senkrecht dazu verläuft. Entsprechend sei das Magnetfeld in drei Komponenten $B_z$, $B_y$ und $B_x$ aufgeteilt, die sich jeweils aus einer Messfeldkomponente $B_{Mz}$, $B_{My}$ und $B_{Mx}$ und einer Kalibrierungsfeldkomponente $B_{Kz}$, $B_{Ky}$ und $B_{Kx}$ zusammensetzen.

Wie in Fig. 1 dargestellt, weist der Magnetfeldsensor 100 zur Erfassung der ersten, zweiten und dritten räumlichen Komponente $B_z$, $B_y$ und $B_x$ eines Magnetfeldes mit der Flussdichte $\overline{B}$ in einem Referenzpunkt 101, die erste Sensorelementanordnung 102 zur Erfassung der ersten Magnetfeldkomponente $B_z$ auf, die die erste Messfeldkomponente $B_{Mz}$, und eine erste Kalibrierungsfeldkomponente $B_{Kz}$ aufweist, bezüglich einer ersten Raumachse z im Referenzpunkt 101. Die Sensorelementanordnung 102 ist vorzugsweise in einem Ausführungsbeispiel durch ein horizontales Hall-Sensorelement realisiert, dessen Messpunkt im Referenzpunkt 101 liegt.

Der Magnetfeldsensor 100 weist ferner die zweite Sensorelementanordnung 104 zur Erfassung der zweiten Magnetfeldkomponente $B_y$ auf, die die zweite Messfeldkomponente $B_{My}$ und die zweite Kalibrierungsfeldkomponente $B_{Ky}$ aufweist, bezüglich der zweiten Raumachse y im Referenzpunkt 101. Die Sensorelementanordnung 104 ist vorzugsweise in einem Ausführungsbeispiel durch eine Anordnung mehrerer vertikaler Hall-Sensorelemente, die paarweise symmetrisch zum Referenzpunkt 101 angeordnet sind, realisiert. Der Magnetfeldsensor 100 weist ferner die dritte Sensorelementanordnung 106 auf, zur Erfassung der dritten Magnetfeldkomponente $B_x$, die die dritte Messfeldkomponente $B_{Mx}$ und die dritte Kalibrierungsfeldkomponente $B_{Kx}$ aufweist, bezüglich der dritten Raumachse x im Referenzpunkt 101. Die Sensorelementanordnung 106 ist vorzugsweise in einem Ausführungsbeispiel durch eine Anordnung mehrerer vertikaler Hall-Sensorelemente, die paarweise symmetrisch zum Referenzpunkt 101 angeordnet sind, realisiert.

Die Erregerleitung 108 des Magnetfeldsensors 100, ist ferner so bezüglich der ersten 102, zweiten 104 und dritten 106 Sensoranordnung angeordnet, dass bei einer Einprägung eines vorgegebenen Stroms in die Erregerleitung 108 die erste vorgegebene Kalibrierungsfeldkomponente $B_{Kz}$ bezüglich der ersten Raumachse z in der ersten Sensorelementanordnung 102 erzeugt wird, die zweite vorgegebene Kalibrierungsfeldkomponente $B_{Ky}$ bezüglich der zweiten Raumachse y in der zweiten Sensorelementanordnung 104 erzeugt wird und die dritte vorgegebene Kalibrierungsfeldkomponente $B_{Kx}$ bezüglich der dritten Raumachse x der dritten Sensorelementanordnung 106 erzeugt wird, wobei die drei Raumachsen z, y und x entlang linear unabhängiger Ortsvektoren verlaufen.

In dem Ausführungsbeispiel von Fig. 1 verlaufen die Ortsvektoren der drei Raumachsen z, y und x orthogonal und die drei Sensorelementanordnungen erfassen das Magnetfeld nach seinen orthogonalen Komponenten $B_z=B_{Mz}+B_{Kz}$, $B_y=B_{My}+B_{Ky}$ und $B_x=B_{Mx}+B_{Kx}$. Zur Vereinfachung wird hier und in der folgenden Beschreibung davon ausgegangen, dass das Magnetfeld mittels orthogonal angeordneter Sensorelementanordnungen nach seinen Komponenten $B_z$, $B_y$ und $B_x$ erfasst wird. In anderen Ausführungsbeispielen der vorliegenden Erfindung können prinzipiell die Sensorelemente in beliebigen Richtungen angeordnet sein insofern, als das sie die räumlichen Komponenten des Messfeldes vollständig erfassen können.

Zur Verdeutlichung des Erzeugens der Kalibrierungsfeldkomponenten $B_{Kz}$, $B_{Ky}$ und $B_{Kx}$ zeigt die Fig. 2 einen Querschnitt des Magnetfeldsensors 100. In dem in Fig. 2 dargestellten Querschnitt ist die erste Sensorelementanordnung 102 in der Mitte zu erkennen, sowie ein Querschnitt durch die zweite Sensorelementanordnung 106, deren Querschnitte jeweils links und rechts der ersten Sensorelementanordnung 102 zu sehen sind. Oberhalb, bezüglich der Hauptoberfläche (x-y-Ebene) des Substrats, der zweiten Sensorelementanordnung 106 verläuft die Erregerleitung 108. Die Geometrie der Erregerleitung 108, d.h. ihre Lage und ihre Abmessungen sind dabei so gewählt, sodass durch einen bekannten eingeprägten Strom $I_E$ eine vorgegebene, auf die Erregerleitung 108 zurückzuführende magnetische Kalibrierungsflussdichte $B_{Kz}$, $B_{Ky}$ und $B_{Kx}$ vorhanden ist. Die Kalibrierungsflussdichte ist über den Strom $I_E$ und die Geometrie bzw. die Eigenschaften der Erregerleitung 108, d.h. deren Höhe, Breite, Dicke, Material, relative Lage usw., definiert einstellbar, und durch Bestimmen und Zuordnen der zugehörigen Hall-Spannung kann die Sensorelementanordnung kalibriert werden. Mit den bekannten magnetischen Kalibrierungsflussdichten lassen sich die von diesen erzeugten Hall-Spannungen zuordnen und der Magnetfeldsensor wird somit kalibrierbar.

Im dargestellten Ausführungsbeispiel wird davon ausgegangen, dass ein Strom $I_E$ durch die Erregerleitung fließt, wobei im in Fig. 2 dargestellten Querschnitt der Strom durch die rechte Erregerleitung 108 in die Anordnung hineinfließen soll und auf der linken Seite durch die Erregerleitung 108 wieder herausfließen soll. Der durch den Erregerleiter 108 fließende Strom erzeugt ein Magnetfeld, dessen Feldlinien durch konzentrische Kreise 200 um den Erregerleiter 108 in Fig. 2 angedeutet sind. Es ist zu erkennen, dass die Sensorelementanordnung 102 von allen Magnetfeldlinien 200 in der gleichen Richtung durchsetzt wird. Es ist weiterhin zu erkennen, dass die in der Fig. 2 dargestellten Querschnitte der Sensorelementanordnung 106 in gegensätzlichem Sinne von den Magnetfeldlinien 200 durchsetzt werden. Analoges gilt für die dritte Sensorelementanordnung 104, die aus Gründen der Übersichtlichkeit in Fig. 2 nicht dargestellt ist, deren Konstellation zur Sensorelementanordnung 106 jedoch äquivalent ist. Der Verlauf der Feldlinien 200, sowie die Orientierung der Feldlinien 200 mit der sie die einzelnen Sensorelementanordnungen durchsetzen, verdeutlicht, dass eine Kalibrierung der Sensorelementanordnung 102 mit dem von der Erregerleiter 108 erzeugten Magnetfeld möglich ist, wohingegen die Kalibrierung der zweiten und dritten Sensorelementanordnungen 104 und 106 einer Kompensation der entgegengesetzt wirkenden Feldlinien bedarf.

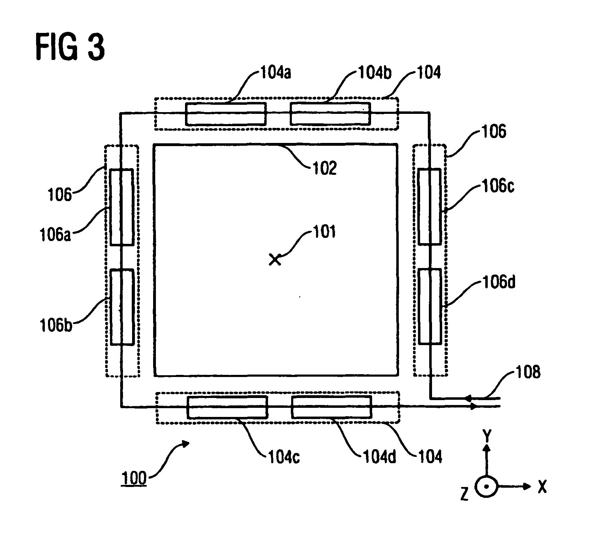

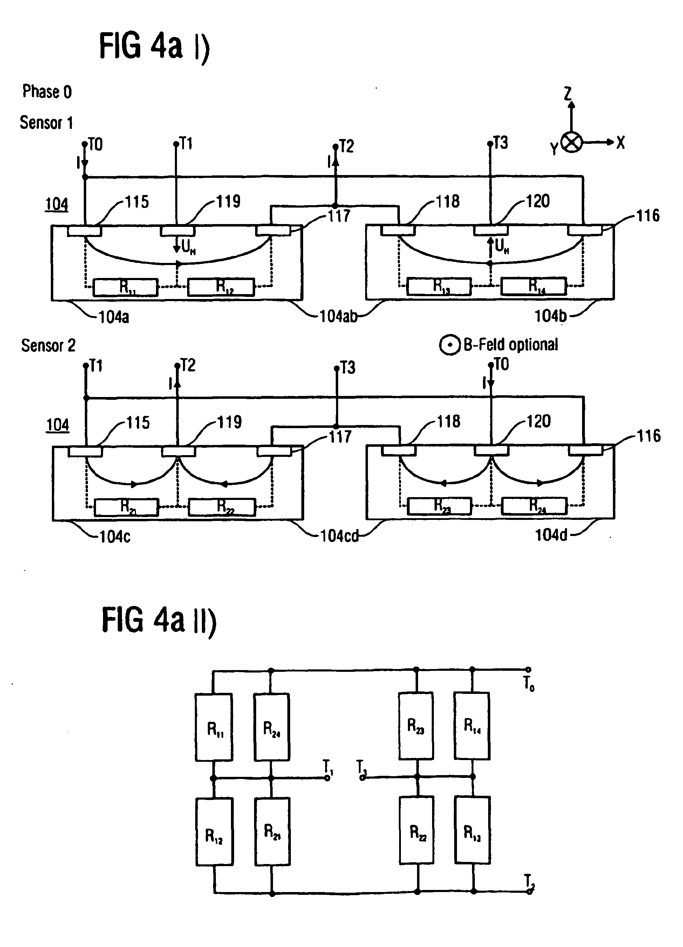

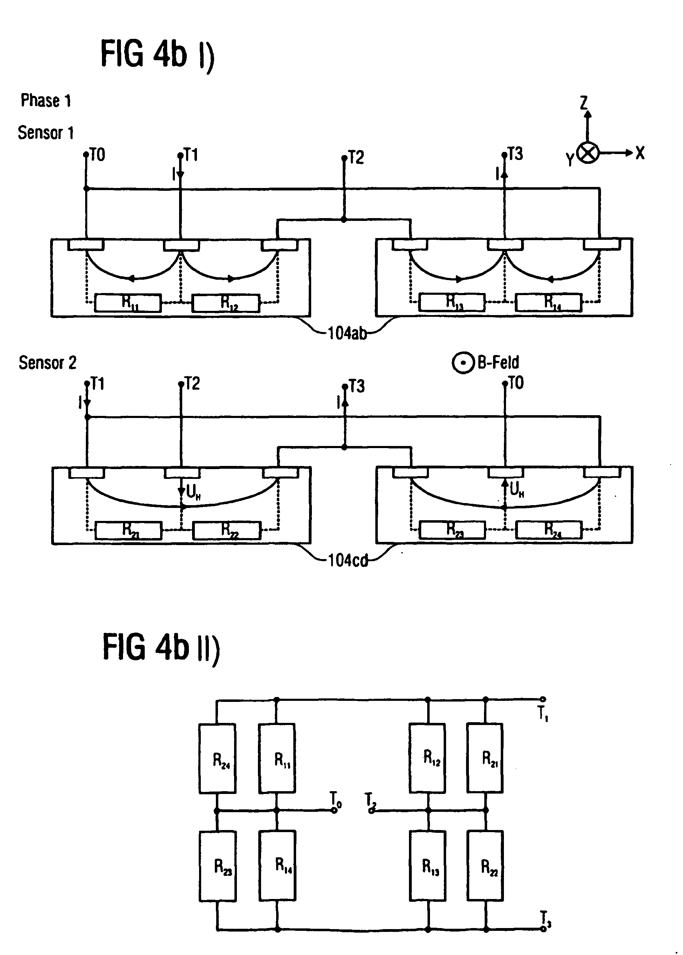

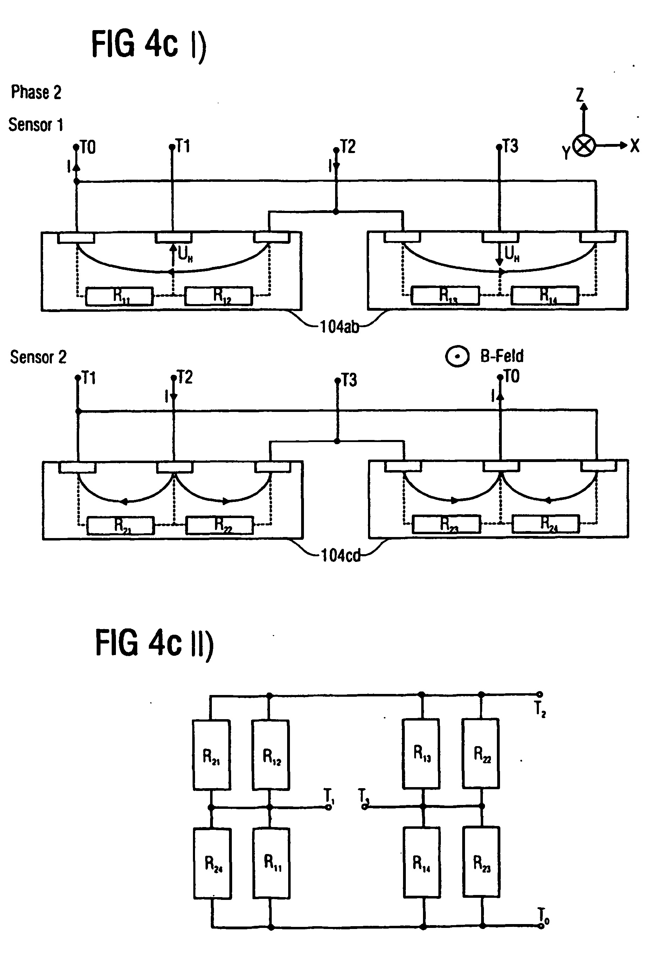

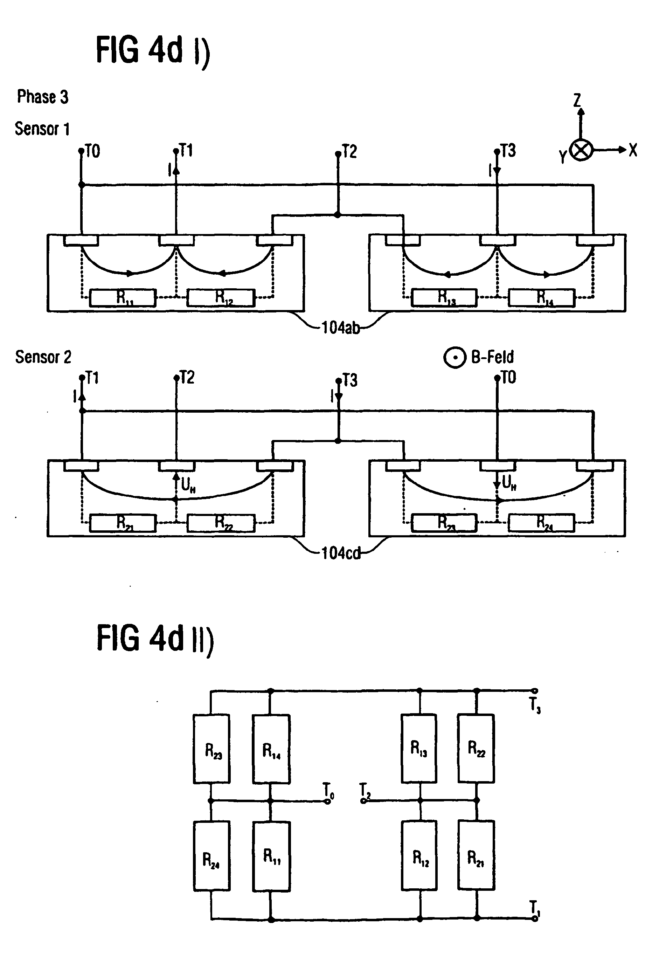

Aus Fig. 2 ist ersichtlich, dass in verschiedenen Betriebphasen, während derer der Erregerstrom unterschiedliche Polungen (Richtungen) annehmen kann und die Sensorelementanordnungen wechselseitig Hall-Spannungen zu Verfügung stellen, eine Kalibrierung des Magnetfeldsensors und eine Erfassung des Messfeldes stattfinden kann. Die erste 102, zweite 104 und dritte Sensorelementanordnung 106 können dabei in verschiedenen Betriebsphasen betrieben werden, wobei jede der ersten 102, zweiten 104 und dritten Sensorelementanordnungen 106 in jeder Betriebsphase ein der Betriebsphase zugeordnetes Messsignal bereitstellt, wobei die den Betriebsphasen zugeordneten Messsignale durch eine erste Linearkombination zu einem ersten Gesamtmesswert kombinierbar sind, so dass der Einfluss der Messfeldkomponente in dem ersten gesamten Messwert reduziert ist, oder die den Betriebsphasen zugeordneten Messsignale durch eine zweite Linearkombination zu einem zweiten Gesamtmesswert kombinierbar sind, so dass der Einfluss der Kalibrierungsfeldkomponente in dem zweiten Gesamtmesswert reduziert ist. Der Einfluss der Messfeldkomponente bzw, der Kalibrierungsfeldkomponente in dem ersten bzw. zweiten gesamten Messwert kann dabei weniger als 10%, 1% oder 0,1% des ersten oder zweiten Gesamtmesswertes betragen. Die Betriebsphasen und die Erfassung der verschiedenen Kalibrierungsfeld- bzw. Messfeldkomponenten wird im Folgenden anhand eines weiteren bevorzugten Ausführungsbeispiels und anhand der Fig. 3 und 4 erläutert.

Aus diesem Grund ist in Fig. 3 ein weiteres bevorzugtes Ausführungsbeispiel der vorliegenden Erfindung dargestellt. Fig. 3 zeigt ein bevorzugtes Ausführungsbeispiel des erfindungsgemäßen Magnetfeldsensors 100. Der Magnetfeldsensor 100 umfasst analog eine erste Sensorelementanordnung 102 um einen Referenzpunkt 101, eine zweite Sensorelementanordnung 104 und eine dritte Sensorelementanordnung 106. Der Magnetfeldsensor 100 umfasst ferner eine Erregerleitung 108. Bei der in Fig. 3 dargestellten Anordnung, weisen sie Sensorelementanordnungen 104 und 106 jeweils 4-Einzelsensorelemente auf, die jeweils paarweise 104ab und 104 cd bzw. 106ab und 106 cd symmetrisch bezüglich des Referenzpunktes 101 angeordnet sind.

Im in Fig. 3 dargestellten Ausführungsbeispiel, können die Sensorelementanordnungen 104 und 106 beispielsweise durch eine Anordnung von vertikalen Hall-Sensorelementen realisiert sein. Die zweite Sensorelementanordnung 104 im Ausführungsbeispiel in Fig. 3 zusammengesetzt aus insgesamt vier Einzelsensorelementen 104a-d. Gleichermaßen ist die dritte Sensorelementanordnung 106 aus vier vorzugsweise gleichen Einzelsensorelementen 106a-d aufgebaut. Das Verwenden von Einzelsensorelementen, wie beispielsweise 104a-d und 106a-d, erlaubt das Verschalten der Einzelelemente in einer Kompensationsverschaltung.

Fig. 4 soll eine erfindungsgemäße Verschaltung der vertikalen Einzelelemente verdeutlichen und das Prinzip eines Kompensationskonzepts erläutern. Fig. 4aI zeigt die Verschaltung von vier vertikalen Hall-Sensorelementen, beispielsweise in der zweiten Sensorelementanordnung 104 mit den Elementen 104a-d. Bei der in Fig. 4aI gezeigten Anordnung, kommen vertikale 3-Pin-Hall-Sensorelemente zum Einsatz, die gemäß Fig. 3 vorzugsweise auf einer Achse liegend miteinander verschaltet sind. Fig. 4aI zeigt zwei vertikale Hall-Sensorelementpaare 104ab und 104cd, wobei die beiden Sensorelemente 104a und 104b das Sensorelementpaar 104ab bilden und die beiden Sensorelemente 104c und 104d das Sensorelementpaar 104cd bilden. Im betrachteten Ausführungsbeispiel bildet je ein vertikales Hall-Sensorelementpaar einen Sensor zur Erfassung einer Magnetfeld-Komponente, die gemäß Fig. 3 symmetrisch um den Referenzpunkt 101 angeordnet sind. Das Sensorelementpaar 104ab und 104cd erfasst dabei beispielsweise die By-Komponente des Magnetfeldes.

Die beiden vertikalen Hall-Sensorelementpaare 104ab und 104cd sind identisch aufgebaut, so dass der Aufbau im Folgenden anhand des vertikalen Hall-Sensorelementpaares 104ab erläutert werden kann. Analoges gilt für die Hall-Sensorelementpaare 106ab und 106cd, die dann beispielsweise die $B_x$-Komponente des Magnetfeldes erfasst. Das vertikale Hall-Sensorelementpaar 104ab setzt sich aus zwei vertikalen Hall-Sensorelementen 104a und 104b zusammen. Jedes vertikale Hall-Sensorelement weist vorzugsweise drei Kontaktflächen auf, wobei in der Anordnung des hier betrachteten Ausführungsbeispiels die äußeren Kontakte 115 und 116, sowie die inneren Kontakte 117 und 118 elektrisch miteinander gekoppelt sind, und die Kontakte 119 und 120 zur Erfassung der Hall-Spannung ausgelegt sind. Insgesamt entstehen so, wie in der Fig. 4aI gezeigt, vier Kontaktanschlüsse T0-T3, über die die beiden Sensorelementanordnungen 104ab und 104cd parallel geschaltet sind. Wird nun ein Strom $I_H$ zwischen den Kontaktanschlüssen T0 und T2 eingeprägt, so kann zwischen den Kontaktanschlüssen T1 und T3 eine Hall-Spannung $U_H$ gemessen werden, wenn ein Magnetfeld mit der entsprechenden Komponente vorhanden ist, wie in Fig. 4aI dargestellt ist.

Der Aufbau des zweiten vertikalen Hall-Sensorelementpaares 104cd ist identisch. Lediglich die Kontaktanschlüsse T0-T3 sind in Bezug auf das vertikale Hall-Sensorelementpaar 104ab um eine Position verschoben, d.h. die Kontakte 115 und 116 sind mit dem Anschluss T1 gekoppelt, die Kontakte 117 und 118 sind mit dem Anschluss T3 gekoppelt, der Kontakt 119 ist mit dem Anschluss T2 gekoppelt und der Kontakt 120 ist mit dem Anschluss T4 gekoppelt.

Wird beim vertikalen Hall-Sensorelementpaar 104cd ein Strom zwischen den Kontaktanschlüssen T0 und T2 eingeprägt, so fungiert die Anordnung als Spannungsteiler und zwischen den Anschlüssen T1 und T3 ist keine Hall-Spannung messbar. Es ist lediglich dann eine Brückenspannung zwischen T1 und T3 messbar, wenn Bauteiltoleranzen oder Inhomogenitäten etc. auftreten. Analoges gilt für das Sensorelementpaar 106ab und 106cd.

Fig. 4aII zeigt ein elektrisches Ersatzschaltbild der Hall-Sensorelementpaaranordnung aus Fig. 4aI. In Fig. 4aI sind zur Verdeutlichung mit gestrichelten Linien die entsprechenden Ohmschen Widerstände zwischen den einzelnen Kontaktanschlüssen T0-T3 eingezeichnet. In Bezug auf das erste vertikale Hall-Sensorelementpaar 104ab ergibt sich zwischen der Kontaktfläche 115 und der Kontaktfläche 119, die mit dem Kontaktanschluss T1 verbunden ist, ein Widerstand von $R_{11}$, zwischen dem Kontaktanschluss T1 und der Kontaktfläche 117 ein Widerstand von $R_{12}$, zwischen der Kontaktfläche 118 und der Kontaktfläche, die mit dem Kontaktanschluss T3 verbunden ist, ein Widerstand von $R_{13}$ und zwischen der Kontaktfläche, die mit dem Kontaktanschluss T3 verbunden ist und der Kontaktfläche 116 ein Widerstand von $R_{14}$. Analog sind die Ersatzwiderstände für das vertikale Hall-Sensorelementpaar 104cd als $R_{21}$, $R_{22}$, $R_{23}$ und $R_{24}$ benannt.

Die Fig. 4aII zeigt das elektrische Ersatzschaltbild bei Parallelschaltung der entsprechenden Anschlüsse T0-T3 der Sensorelementpaare 104ab und 104cd, das einer Wheatstone-Brücke entspricht. Gemäß der Verschaltung, die in Fig. 4aI dargestellt ist und unter der Annahme, dass kein magnetisches Feld vorhanden ist und eine Spannung U zwischen den Kontaktanschlüssen T0 und T2 angelegt ist, sodass ein Strom I eingeprägt wird, ergibt sich zwischen den Kontaktanschlüssen T1 und T3 während einer ersten Messphase, der Messphase 0 eine Spannung von

$$U_0 = U\left[\frac{R_{14\|23}}{R_{14\|23} + R_{13\|22}} - \frac{R_{11\|24}}{R_{11\|24} + R_{12\|21}}\right] \qquad (1)$$

Fig. 4bI zeigt die Beschaltung der beiden vertikalen Hall-Sensorelementpaare 104ab und 104cd während der Messphase 1. Es wird nun ein Strom zwischen den Kontaktanschlüssen T1 und T3 über die Spannung U eingeprägt, so dass das vertikale Hall-Sensorelementpaar 104ab nun als Spannungsteiler fungiert, während das vertikale Hall-Sensorelementpaar 104cd an den Klemmen T0, T2 eine Hall-Spannung zur Verfügung stellt.

Die Fig. 4bII zeigt das elektrische Ersatzschaltbild der Sensorelementanordnung während der Messphase 1 unter der Voraussetzung, dass kein Magnetfeld vorhanden ist. Für die Messphase 1 ergibt sich zwischen den Klemmen T0 und T2

$$U_1 = U\left[\frac{R_{12\|21}}{R_{12\|21} + R_{13\|22}} - \frac{R_{11\|24}}{R_{11\|24} + R_{14\|23}}\right]. \qquad (2)$$

In analoger Weise zeigt die Fig. 4cI die Anordnung während der Messphase 2. Es wird nun ein Strom I über die Spannung U zwischen den Klemmen T2 und T0 eingeprägt, so dass das vertikale Hall-Sensorelementpaar 104cd während Messphase 2 als Spannungsteiler fungiert und das vertikale Hall-Sensorelementpaar 104ab in Bezug auf die Messphase 0 in umgepolter Richtung betrieben wird.

Die Fig. 4cII zeigt das elektrische Ersatzschaltbild, wieder unter der Voraussetzung, dass kein magnetisches Feld vorhanden ist. Es ergibt sich für diesen Fall zwischen den Klemmen T1 und T3

$$U_2 = U\left[\frac{R_{13\|22}}{R_{13\|22} + R_{14\|23}} - \frac{R_{12\|21}}{R_{12\|21} + R_{11\|24}}\right]. \qquad (3)$$

Fig. 4dI zeigt die Anordnung der beiden vertikalen Hall-Sensorelementpaare 104ab und 104a während der Messphase 3. Während der Messphase 3 wird zwischen den Kontaktanschlüssen T3 und T1 ein Strom I eingeprägt, so dass das vertikale Hall-Sensorelementpaar 104ab als Spannungsteiler fungiert. Das vertikale Hall-Sensorelementpaar 104cd wird im Vergleich zur Messphase 1 in umgepolter Richtung betrieben.

Die Fig. 4dII zeigt das elektrische Ersatzschaltbild, wobei sich zwischen den Klemmen T0 und T2

$$U_3 = U\left[\frac{R_{13\|22}}{R_{13\|22} + R_{12\|21}} - \frac{R_{14\|23}}{R_{14\|23} + R_{11\|24}}\right] \qquad (4)$$

ergibt.

Die Gleichungen 1-4 zeigen, dass

$$U_{H0} + U_{H2} = 0 \qquad\qquad (5)$$

und

$$U_{H1} + U_{H3} = 0, \qquad\qquad (6)$$

das bedeutet, dass durch Addition der gemessenen Spannungen aus den einzelnen Messphasen, eventuelle Offset-Spannungen kompensiert werden können. Es wird in diesem Zusammenhang auch von Spinning-Current gesprochen, da die Stromeinspeisung über die Kontaktanschlüsse rotiert. Mit dem beschriebenen Verfahren lassen sich also Abweichungen, die sich durch Bauelementtoleranzen wie beispielsweise Verunreinigungen, Asymmetrien, piezoelektrische Effekte, Alterungserscheinungen usw. entstehen, kompensieren. Die Gleichungen 1 bis 6 zeigen, dass dies für beliebige Widerstandswerte möglich ist, da keine Annahmen über spezielle Widerstandswerte in den Sensorelementen gemacht wurden.

Weiterhin soll durch die Figuren 4a-d verdeutlicht werden, dass während einer Messphase jeweils nur ein vertikales Hall-Sensorelementpaar aktiv ist, während das andere als Spannungsteiler geschaltet ist. Bezugnehmend auf die Fig. 2 bedeutet dies, dass während der einzelnen Messphasen jeweils nur eine Seite der Sensorelementanordnung 106 auf die magnetischen Feldlinien 200 reagiert, während die andere als Spannungsteiler fungiert, unabhängig von dem gegenwärtig anliegenden Magnetfeld.

So kommen im Ausführungsbeispiel gemäß Fig. 3 bevorzugt vertikale 3-Pin-Hall-Sensorelementpaare zum Einsatz, zur Implementierung der zweiten Sensorelementanordnung 104 und der dritten Sensorelementanordnung 106. Die anhand der Figuren 4a-d beschriebenen Messphasen können unabhängig von der räumlichen Ausrichtung eines Hall-Sensorelementes vollzogen werden. Um bei der Verwendung von vertikalen 3-Pin-Sensoren, das Spinning-Current-Verfahren zu verwenden, d.h. um vertikale 3-Pin-Sensoren mit einem Kompensationsverfahren zu betreiben, müssen im Betrieb zwei Grundelemente verwendet werden.

Gemäß einem Ausführungsbeispiel der vorliegenden Erfindung, das in Fig. 3 dargestellt ist, können beispielsweise jeweils zwei vertikale 3-Pin-Hall-Sensorelementpaare parallel geschaltet werden. Diese sind dabei immer so verschaltet, dass jeweils zwei derselben als ein Sensor die Hall-Spannung liefern, während die anderen zwei als Spannungsteiler arbeiten und so den Offset reduzieren. Beispielsweise wird so in der Messphase 0 eine Steuerspannung zwischen die Kontaktanschlüsse T0 und T2 angelegt, bezugnehmend auf die Fig. 4aI führt dies beim vertikalen Hall-Sensorelementpaar 104ab zum Ausbilden der Hall-Spannung $U_H$ zwischen den Kontaktanschlüssen T1 und T3. Das vertikale Hall-Sensorelementpaar 104cd, dessen Kontakte um eine Phase verschoben sind, arbeitet lediglich als Spannungsteiler und leistet keinen Beitrag zur Hall-Spannung. Das Signal des vertikalen Hall-Sensorelementpaares 104cd wird nur dazu verwendet, den Offset zu reduzieren.

Während der Messphase 1 wird die Steuerspannung zwischen den Kontaktanschlüssen T1 und T3 angelegt. Dies führt dazu, dass die Hall-Spannung jetzt an dem vertikalen Hall-Sensorelementpaar 104cd entsteht und das vertikale Hall-Sensorelementpaar 104ab nur als Spannungsteiler wirkt. Die Messphase 2 ist das Äquivalent zur Messphase 0, wobei die Steuerspannung dann zwischen den Kontaktanschlüssen T2 und T0 angelegt wird. Das vertikale Hall-Sensorelementpaar 104ab erzeugt dann die Hall-Spannung, wohingegen der Sensor 2 wieder als Spannungsteiler arbeitet. Die Messphase 3 ist analog das Äquivalent zur Messphase 1, die Steuerspannung wird zwischen den Kontaktanschlüssen T3 und T1 angelegt. Das vertikale Hall-Sensorelementpaar 104ab arbeitet dann als Spannungsteiler, respektive das vertikale Hall-Sensorelementpaar 104cd erzeugt die Hall-Spannung.

Vorzugsweise werden für Sensoren im Rahmen der Erfindung vertikale 3-Pin-Hall-Sensoren eingesetzt. Grundsätzlich können aber auch alle jeweiligen anderen vertikalen Hall-Sensoren, wie z.B. als vertikale Hall-Sensoren ausgeführte 4-pinnige, 5-pinnige, 6-pinninge, etc. Einzelsensorelemente im Rahmen der Erfindung zum Einsatz kommen. Entscheidend ist nur, dass diese in Betriebsphasen mit unterschiedlichen Empfindlichkeiten betreibbar sind oder die unterschiedlichen Empfindlichkeiten durch entsprechende Betriebsweisen erzeugt werden können. Dabei sind sowohl symmetrisch angeordnete Einzelsensorelemente als auch symmetrisch angeordnete Verschaltungen von Einzelsensorelementen, wie exemplarisch anhand des Ausführungsbeispiels in Fig. 4 erläutert wurde, denkbar. Beispielsweise könnten in einem Ausführungsbeispiel der vorliegenden Erfindung auch 5-pinninge Sensoren zum Einsatz kommen, wobei jeweils ein 5-pinninges Einzelelement eine erfindungsgemäße Sensorelementanordnung realisiert, da 5-pinnige Einzelsensorelemente bereits für sich sowohl Spinning-Current-fähig als auch mit unterschiedlichen Empfindlichkeiten betreibbar sind. In diesem Ausführungsbeispiel werden dann die symmetrisch angeordneten 5-pinnigen Einzelsensorelemente gleichzeitig mit unterschiedlicher Empfindlichkeit betrieben, so dass sich die gegensinnig orientierten Kalibrierungsfeldkomponenten nicht volständig kompensieren und eine Kalibrierungsfeldkomponente und/oder eine Messfeldkomponente extrahiert werden kann. Erfindungsgemäß sind also auch zwei symmetrisch angeordnete Sensorelemente dazu geeignet, sowohl eine Messfeldkomponente als auch eine Kalibrierungsfeldkomponente in verschiedenen Betriebphasen zu erfassen, die dann über entsprechende Kombinationen der Messgrößen aus den einzelnen Betriebsphasen extrahierbar sind. Damit ist auch ein solcher Sensor im Betrieb kalibrierbar.

Zur Vereinfachung der Beschreibung des erfindungsgemäßen Konzepts zur Erfassung von räumlichen Komponenten eines Magnetfeldes in einem Referenzpunkt, sowie des Kalibrierungs- und Messverfahrens, bezieht sich die vorliegende Beschreibung auf eine Realisierung eines Magnetfeldsensors basierend auf vertikalen 3-pinnigen Sensorelementen zur Erfassung der y- und x-Komponenten des Kalibrierungs- bzw. Messfeldes und auf horizontalen Sensorelementen zur Erfassung der jeweiligen z-Komponenten. Prinzipiell ist der erfindungsgemäße Magnetfeldsensor und das erfindungsgemäße Verfahren auch durch andere Kombinationen verschiedener Einzelsensorelemente denkbar.

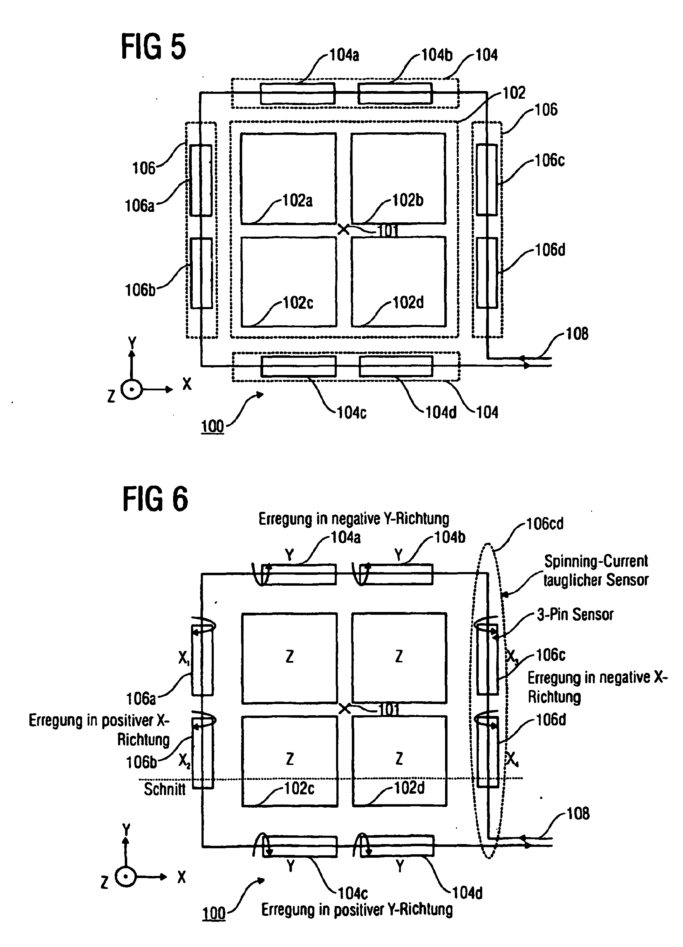

Die Fig. 5 zeigt ein weiteres Ausführungsbeispiel eines Magnetfeldsensor 100 gemäß einem alternativen Ausführungsbeispiel der vorliegenden Erfindung. In Fig. 5 sind die erste Sensorelementanordnung 102, die zweite Sensorelementanordnung 104 und die dritte Sensorelementanordnung 106 als gestrichelte Linien gekennzeichnet. Weiterhin zeigt die Fig. 5 die Erregerleitung 108. Wie bereits anhand des vorigen Ausführungsbeispiels erläutert, werden nun Einzelelemente miteinander verschaltet, um die drei Sensorelementanordnungen 102, 104 und 106 zu realisieren. So werden die zweite Sensorelementanordnung 104 und die dritte Sensorelementanordnung 106 beispielsweise durch die anhand der Figuren 4a-d erläuterten 3-pinnigen vertikalen Hall-Sensorelemente und Hall-Sensorelementpaare realisiert. Die zweite Sensorelementanordnung 104 ist in Fig. 5 durch die vier vertikalen Hall-Sensorelemente 104a-d, die dritte Sensorelementanordnung 106 ist durch die vertikale Hall-Sensorelemente 106a-d realisiert.

Die erste Sensorelementanordnung 102, die bisher durch einen horizontalen Hall-Sensor realisiert dargestellt wurde, weist im Ausführungsbeispiel gemäß der Fig. 5 vier Einzelelemente 102a-d auf. Der in Fig. 5 dargestellte Magnetfeldsensor 100 ist also eine Kombination aus vier horizontalen Hall-Sensoren 102a-d und acht vorzugsweise vertikalen 3-Pin-Hall-Sensoren 104a-d und 106a-d. In einem bevorzugten Ausführungsbeispiel sind die von den jeweiligen Sensoren gemessenen Messebenen orthogonal zueinander, wobei im allgemeinen Fall die Annahme genügt, dass die Messebenen der einzelnen Sensoren entlang linear unabhängiger Ortsvektoren verlaufen, so dass alle Magnetfeldkomponenten des Raumes erfasst werden können.

In dem Ausführungsbeispiel in Fig. 5 werden je vier vertikale 3-Pin-Hall-Sensorelemente 104a-d und 106a-d für jede der beiden tangential zur Oberfläche der Fig. 5 verlaufenden Achsen verwendet, wobei alle Sensoren symmetrisch um einen Mittelpunkt oder Referenzpunkt 101 angeordnet sind. Es wird davon ausgegangen, dass die vertikalen Hall-Sensorelemente entsprechend der obigen Beschreibung verschaltet sind und dass die Sensoren in einem Spinning-Current-Betrieb gemäß der oben beschriebenen Messphasen 0 bis 3 betrieben werden. Zur näheren Erläuterung des erfindungsgemäßen kalibrierbaren Magnetfeldsensors und des Kalibrierungsverfahrens wird nun während der Messphasen auch der Erregerleiter 108 bestromt.

Die Fig. 6 zeigt noch einmal das Ausführungsbeispiel eines Magnetfeldsensors 100 aus Fig. 5, wobei zwecks einer besseren Übersicht nur die zur Erläuterung der Funktionsweise relevanten Bezugszeichen angegeben sind. In Fig. 6 fließt ein Strom durch den Erregerleiter 108 und somit wird ein Kalibrierungsfeld erzeugt. In der Fig. 6 befindet sich neben jedem vertikalen Hall-Sensorelement ein Pfeil, der die Richtung der Feldlinien des Kalibrierungsfeldes angibt. Es wird ferner davon ausgegangen, dass jeweils zwei der vertikalen 3-Pin-Hall-Sensoren innerhalb eines Hall-Sensorelementpaares, wie beispielsweise dem Hall-Sensorelementpaar 106cd in Fig. 6, in einem Spinning-Current-Modus betrieben werden.

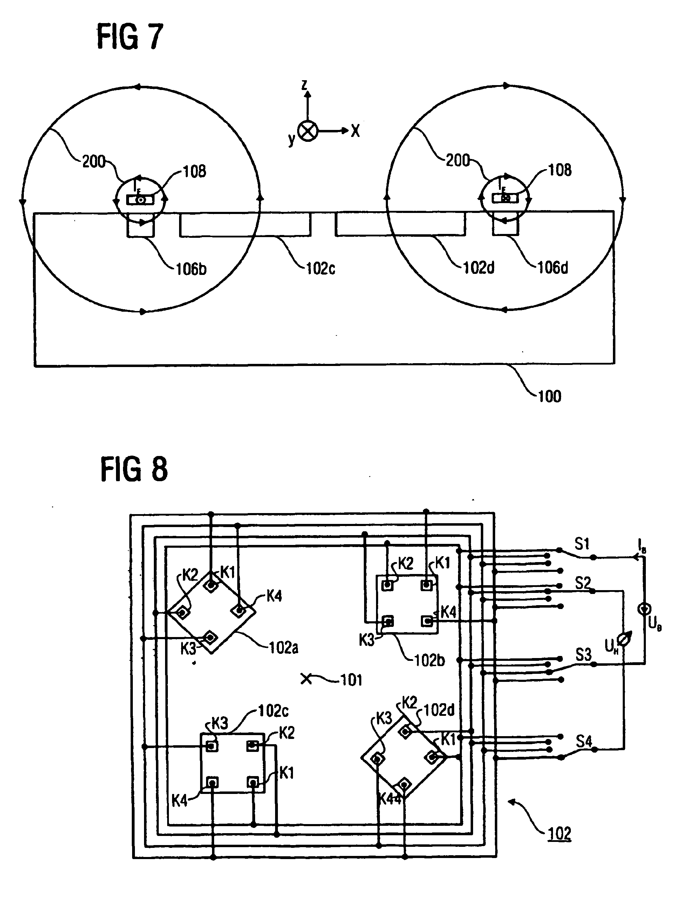

Fig. 7 verdeutlicht noch einmal den Verlauf der magnetischen Feldlinien 200 in Bezug auf die Sensorelemente 106b, 106d, 102c und 102d. Die Erregung mit einem Erregerleiter erscheint zunächst nicht möglich, da das erzeugte Feld einmal in positiver und einmal in negativer Richtung auf die vertikalen Hall-Sensorelemente 106b und 106d wirkt. Unter Berücksichtigung der Funktionsweise der vertikalen 3-Pin-Hall-Sensorelemente 106a-d und 104a-d im Spinning-Current-Betrieb, d.h. während den Messphasen 0 bis 3, wird klar, dass während einer Messphase jeweils ein Hall-Sensorelementpaar als Spannungsteiler wirkt, und somit keine Magnetfeldkomponente erfasst.

Da innerhalb einer Sensorelementanordnung die beiden vertikalen im Spinning-Current-Betrieb betriebenen Hall-Sensorelementpaare immer nur abwechselnd aktiv sind, ist es möglich einen einzigen Erregerleiter 108 zu verwenden. Der Strom im Erregerleiter wird zwischen den einzelnen Messphasen so umgeschaltet, dass er seine Erregungsrichtung ändert und somit die Hall-Sensorelementpaare im jeweils aktiven Zustand in der selben Richtung erregt. Für die horizontalen Sensoren 102c und 102d bedeutet dies aber, dass sie in einer Messphase in positiver und in der anderen Messphase in negativer Richtung erregt werden. Es ist deswegen erforderlich, dass alle vier Phasen des Spinning-Current-Betriebs beachtet werden, damit der komplette Sensor funktionsfähig wird.

Die folgende Tabelle verdeutlicht die Ansteuerung der erfindungsgemäßen Anordnung, wobei in der Spalte Steuerspannung die Anschlüsse der Steuerstromeinprägung angegeben sind, in der Spalte Hallabgriff die Anschlüsse an denen die Hall-Spannung abgegriffen wird, in der Spalte Erreger die Polung des Erregerstroms, in der Spalte Hallspannung das Vorzeichen der Hall-Spannung und in den letzten beiden Spalten die Polungen der Kalibrierungsfeldkomponenten des Kalibrierungsfeldes:

| Messphase | Steuersp. | Hallabgr. | Erreger | Hallsp. | Kalibr.X/Y | Kalibr.Z |
|-----------|-----------|-----------|---------|---------|------------|----------|
| 0 | T0-T2 | T1-T3 | + | + | + | + |
| 1 | T1-T3 | T2-T0 | - | + | + | - |
| 2 | T2-T0 | T3-T1 | - | + | - | - |
| 3 | T3-T1 | T0-T1 | + | + | - | + |

Der Erregerleiter 108 wird in der Messphase 0 mit einem positiven Strom gespeist, in den Messphasen 1 und 2 mit einem negativen Strom und in der Messphase 3 wiederum mit einem positiven Strom. Daraus ergibt sich, dass während einer laufenden Kalibrierung eine Hall-Spannung gemessen werden kann. Für die vertikalen Hall-Sensorelemente 104a-d und 106a-d findet ein Vorzeichenwechsel der Erregerleitung 108 zwischen den Messphasen 0 und 1 statt, so dass das Kalibrierungsfeld an den jeweils aktiven vertikalen Hall-Sensorelementen in der gleichen Richtung anliegt. Weiterhin findet bezüglich der vertikalen Hall-Sensorelemente 104a-d und 106a-d ein Vorzeichenwechsel des Kalibrierungsfeldes von den Messphasen 0 und 1 zu den Messphasen 2 und 3 statt, wodurch sich die Kalibrierungsfeldkomponenten beim Addieren aller vier Spinning-Current-Phasen gegenseitig aufheben. Da im Fall der Addition der vier gemessenen Hall-Spannungen $U_H$ während der vier Messphasen, die eigentlichen Hall-Spannungen Vorzeichenrichtig addiert werden, verbleibt bei dieser Vorgehensweise lediglich der Anteil, der auf das Messfeld zurückzuführen ist.

In Bezug auf die horizontalen Hall-Sensorelemente 102a-d, liegt das Kalibrierungsfeld an allen horizontalen Hall-Sensorelementen in der gleichen Richtung an. Dies bedeutet, dass mit jedem Vorzeichenwechsel des Stromes in dem Erregerleiter 108 auch ein Vorzeichenwechsel der entsprechenden Kalibrierungsfeldkomponente und der zugeordneten gemessenen Spannung stattfindet. Dies sorgt wiederum dafür, dass beim Addieren aller in den vier Spinning-Current-Phasen gemessenen Messsignale sich die Anteile des Kalibrierungsfeldes gerade aufheben, wohingegen sich die Anteile des Messfeldes konstruktiv überlagern und somit im Idealfall um das Kalibrierungsfeld bereinigt vorliegen. In der Praxis ist eine Reduktion der Kalibrierungsfeldkomponente auf Toleranzbereiche der Größenordnung von weniger 10%, 1% oder 0,1% des Gesamtmesswertes möglich.

Um nun während einer laufenden Messung, d.h. wenn sich der Magnetfeldsensor in einem magnetischen Feld befindet, eine Kalibrierung durchführen zu können, kommt die gleiche Vorgehensweise zur Anwendung. Bezüglich der vertikalen Hall-Sensorelemente 104a-d und 106a-d liegt in den Messphasen 0 und 1 das Kalibrierungsfeld in positiver Richtung an, wohingegen in den Messphasen 2 und 3 das Kalibrierungsfeld in negativer Richtung an den aktiven vertikalen Hall-Sensorelementen anliegt. Die Kalibrierungs-Hall-Spannung kann nun erhalten werden, indem die Messsignale aus den ersten beiden Phasen addiert werden und die Messsignale der letzten beiden Messphasen subtrahiert werden. Hierdurch wird erreicht, dass sich das eigentliche zu messende Signal, also diejenigen Messsignale, die auf das Messfeld zurückzuführen sind, gerade gegenseitig aufheben, wohingegen sich nun diejenigen Messsignale, die auf das Kalibrierungsfeld zurückzuführen sind, konstruktiv überlagern. Durch eine entsprechende Kombination der Messsignale aus den einzelnen Messphasen lässt sich also somit auch eine Kalibrierungsfeldkomponente extrahieren, selbst wenn gleichzeitig ein weiteres zu messendes Magnetfeld vorhanden ist.

In Bezug auf die horizontalen Hall-Sensorelemente 102a-d liegt das Kalibrierungsfeld in den Messphasen 0 und 3 in positiver Richtung und in den Messphasen 1 und 2 in negativer Richtung an. Die auf das Kalibrierungsfeld zurückzuführende Kalibrierungs-Hall-Spannung, kann nun durch addieren der Messsignale der Messphasen 0 und 3 und Subtrahieren der Messsignale der Messphasen 1 und 2 erreicht werden. Auch in diesem Fall kann durch entsprechendes Kombinieren ein Messsignal extrahiert werden, das lediglich auf das Kalibrierungsfeld zurückzuführen ist, da sich die Messfeldkomponenten im Idealfall vollständig gegenseitig aufheben. In der Praxis ist eine Reduktion der Messfeldkomponente auf Toleranzbereiche der Größenordnung von weniger als 10%, 1% oder 0,1% des Gesamtmesswertes möglich.

Das Messsignal, das auf die Messfeldkomponente zurückzuführen ist ergibt sich bei allen diesen Hall-Sensoren durch Aufaddieren der in den vier Spinning-Current-Messphasen gemessenen Messsignale.

Maximale Hall Spannung = Summe der Signale der einzelnen Messphasen 0 bis 3.

Zum Extrahieren der Kalibrierungsfeldkomponente werden die Messsignale aus den vier Messphasen bzw. Spinning-Current-Phasen folgendermaßen addiert:

`Kalibrierungsfeldkomponente der vertikalen Sensoren = Messphase 0 + Messphasen 1 - Messphase 2 - Messphase 3.`

`Kalibrierungsfeldkomponente der horizontalen Sensoren = Messphase 0 - Messphase 1 - Messphase 2 + Messphase 3.`

Prinzipiell ist es möglich durch Verpolen des Erregerstroms und vertauschen der Messphasen auch andere Kombinationsmöglichkeiten zu schaffen. Erfindungsgemäß ist es allgemein möglich, durch verschiedene Kombinationen der Messsignale jeweils die Messfeldkomponente mit reduzierter Kalibrierungsfeldkomponente, bzw. die Kalibrierungsfeldkomponente mit reduzierter Messfeldkomponente zu extrahieren. Es ist zu erkennen, dass die auf das Messfeld zurückzuführende Messsignalkomponente durch diese Linearkombination theoretisch eliminiert wird und nur eine Kalibrierungsfeldkomponente übrig bleibt. In einer praktischen Anwendung kann durch eine Linearkombination der hier beschriebenen Art der Einfluss eines Messfeldes erheblich reduziert werden, um eine Kalibrierungsfeldkomponente zu extrahieren. Mittels einer anderen Linearkombination ist es möglich die Kalibrierungsfeldkomponente weitgehend zu unterdrücken, um eine Offset-kompensierte Messfeldkomponente zu extrahieren. In der Praxis ist eine Unterdrückung bis auf Anteile der Größenordnung von weniger als 10%, 1% oder 0,1% des Gesamtmesswertes möglich.

Fig. 8 zeigt ein weiteres Ausführungsbeispiel der ersten Sensorelementanordnung 102. Fig. 8 zeigt eine alternative Ausführungsform bei der je zwei horizontale Hall-Sensorelementpaare in einem Viereck platziert sind, wobei die einzelnen horizontalen Hall-Sensorelementpaare diagonal zum Referenzpunkt 101 angeordnet sind. Die erste Sensorelementanordnung 102 besteht hier insgesamt aus vier horizontalen Hall-Sensorelementen 102a-d. Ferner weist jedes Hall-Sensorelement 102a-d vier Kontaktelektroden K1 bis K4 auf. Bei dem in Fig. 8 gezeigten Ausführungsbeispiel sind jeweils die Kontaktelektroden K1, die Kontaktelektroden K2, die Kontaktelektroden K3 und die Kontaktelektroden K4 der einzelnen Hall-Sensorelemente 102a-d untereinander parallel geschaltet angeordnet und ohne dazwischenliegende Schalter fest miteinander verdrahtet. Bei der vorliegenden Darstellung bilden die Kontaktelektroden K1 und die Kontaktelektroden K3 der Hall-Sensorelemente 102a-d die Stromeinprägungskontakte, wohingegen die Kontaktelektroden K2 und die Kontaktelektroden K4 der Hall-Sensorelemente 102a-d die Messanschlüsse zur Erfassung einer Hall-Spannung liefern. Die Kontaktelektroden zum Zuführen eines Betriebsstromes und die Kontaktelektroden zur Erfassung einer Hall-Spannung sind in den einzelnen Hall-Sensorelementen derart angeordnet, dass die Stromrichtung des eingeprägten Betriebsstromes jeweils senkrecht zu der Richtung der abgegriffenen Hall-Spannung ist.

Bei der vorliegenden Anordnung sind die Betriebsstromrichtungen in den beiden Hall-Sensorelementen jedes Hall-Sensorelementpaars, also 102a und 102d bzw. 102b und 102c, jeweils um 90° zueinander gedreht. Die Stromrichtungen des zweiten Hall-Sensorelementepaars sind gegenüber den Stromrichtungen des ersten Hall-Sensorelementpaars um einen Winkel von 45° versetzt.

Bei der praktischen Ausführung der erfindungsgemäßen Hall-Sensoranordnung kann der Winkel, um den die Betriebsstromrichtung in den beiden Hall-Sensorelementen jedes Paars zueinander gedreht sind, auch von dem Idealwert 90° abweichen und beispielsweise in einem Bereich z. B. zwischen 80 und 100° liegen, wobei die Winkel in diesem Bereich im Sinne des vorliegenden Ausführungsbeispiels als. Winkel von im Wesentlichen 90° gesehen werden. Die untereinander fest verschalteten Kontaktelektroden K1, K2, K3 und K4 der Hall-Sensorelemente 102a-d sind mit Schaltern S1 S2, S3 und S4 verbunden, die jeweils zwischen vier Positionen, d.h. zwischen den Kontaktelektroden K1, K2, K3 und K4 umgeschaltet werden können. Mit den Schaltern S1 bis S4 können die Kontaktelektroden K1 bis K4 in den einzelnen Messphasen der Hall-Sensoranordnung als Versorgungsanschlüsse zum Zuführen eines Betriebsstromes $I_B$ oder als Messanschlüsse zur Erfassung einer Hall-Spannung $U_H$ jeweils gemeinsam umgeschaltet werden. Das Umschalten der Schalter ermöglicht somit ein Spinning-Current-Verfahren innerhalb der ersten Sensorelementanordnung 102.

Prinzipiell sind auch weitere Ausführungsbeispiele denkbar. Eine weitere Ausführungsform einer Hall-Sensoranordnung, die hier nicht explizit dargestellt ist, kann beispielsweise darin bestehen, dass mehr als zwei Paare von Hall-Sensorelementen verwendet werden. Dies gilt ebenso in Bezug auf die vertikalen Hall-Sensorelementanordnungen, die im allgemeinen Fall ebenfalls nicht auf die Verwendung von zwei oder vier Hall-Sensorelementen beschränkt sind. Auch im Fall, dass mehrere Hall-Sensorelemente verwendet werden, können beispielsweise die Stromrichtungen in den beiden Hall-Sensorelementen eines jeden Paars jeweils um, im Wesentlichen 90° zueinander versetzt sein, wie dies auch im Ausführungsbeispiel aus Fig. 8 der Fall ist. Auch hier müssen die beiden Hall-Sensorelemente eines Paares geometrisch gleich und bezüglich der Abmessung der Hall-Sensorelemente eng benachbart sein und können in der Gesamtsensoranordnung untereinander, nebeneinander oder in einer Diagonalen angeordnet sein. Hinsichtlich der Geometrie der Anordnung ist in gewissen Toleranzgrenzen ein Maß an Symmetrie um den zu bemessenden Referenzpunkt erforderlich. Die Stromrichtungen der mindestens zwei Hall-Sensorelementpaare sind jeweils untereinander und im Winkel von im Wesentlichen 90°/n gedreht, wobei n die Anzahl der insgesamt verwendeten Hall-Sensorelementpaare ist, wobei gilt n ≥ 2. Wenn z. B. drei Hall-Sensorelementpaare verwendet werden, so sind die Stromrichtungen in den einzelnen Hall-Sensorelementpaaren somit um einen Winkel von im Wesentlichen 30° untereinander versetzt. Die Sensorelementpaare der Sensoranordnung sind entweder nebeneinander liegend oder in der Nebendiagonalen angeordnet, wobei sich die Hall-Sensorelemente paarweise möglichst nahe aneinander befinden.

Zusammenfassend lässt sich bezüglich des erfindungsgemäßen Konzepts des im Messbetrieb kalibrierbaren magnetischen 3D-Punktsensors feststellen, das Magnetsensoren gemäß den Ausführungsbeispielen der vorliegenden Erfindung also mit nur einem Erregerleiter auskommen. Sie bieten den Vorteil das alle drei Feldkomponenten in sehr guter Näherung in einem Punkt gemessen werden können, wobei Offsets, die durch beispielsweise Bauteiltoleranzen, Verunreinigungen im Halbleitermaterial, Strukturinhomogenitäten im Halbleitermaterial usw. hervorgerufen werden, durch beispielsweise das Spinning-Current-Prinzip kompensiert werden können und die Messwerte damit Offset-arm zur Verfügung gestellt werden können. Durch die Verwendung der Erregerschleife, die beliebig viele Windungen aufweisen kann, wird ein einfacher Wafer-Test, also ein Onchip-Test aller drei Sensoren ermöglicht. Weiterhin ist es durch das Kombinieren der Messsignale aus den einzelnen Messphasen möglich, im laufenden Messbetrieb einen Selbsttest zuzulassen, da sowohl Messsignalanteile, die auf die Messfeldkomponenten zurückgehen zum einen, als auch Messsignalanteile, die auf Kalibrierungsfeldkomponenten zurückgehen zum anderen erheblich reduzierbar sind. Es ist somit möglich, an einem solchen Magnetfeldsensor im laufenden Betrieb eine Empfindlichkeitskalibrierung durchzuführen. Die Erregerschleife selbst lässt sich ebenfalls testen, da ein Ausfall aller drei Sensoren mit getrennter Auswerteelektronik sehr unwahrscheinlich ist.

Ferner wird darauf hingewiesen, das die vorliegende Erfindung am Beispiel von vertikalen 3-Pin-Hall-Sensoren erläutert wurde, diese im allgemeinen Fall aber nicht auf diese beschränkt ist. Beispielsweise können auch 5-Pin-Hall-Sensoren (siehe z.B. DE 101 50 955 und DE 101 50 950) oder generell beliebige Sensoren, wobei auch kreisförmige oder kreissegmentförmige Anordnungen denkbar sind, zum Einsatz kommen. Hinsichtlich der Geometrie des Magnetfeldsensors sollten die verwendeten Sensorelementanordnungen jeweils das Magnetfeld in einem gemeinsamen Referenzpunkt erfassen, was im Wesentlichen durch paarweise symmetrische Anordnungen um den Referenzpunkt herum analog zur obigen Beschreibung erreicht werden kann. Das Messverfahren, also das Kompensationsverfahren als auch das Kalibrierungsverfahren, ist dann den entsprechenden Hall-Sensoren und deren Geometrie entsprechend anzupassen.

Insbesondere wird darauf hingewiesen, dass abhängig von den Gegebenheiten das erfindungsgemäße Schema auch in Software implementiert sein kann. Die Implementierung kann auf einem digitalen Speichermedium, insbesondere einer Diskette oder einer CD mit elektronisch auslesbaren Steuersignalen erfolgen, die so mit einem programmierbaren Computersystem und/oder Mikrocontroller zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner und/oder Mikrocontroller abläuft. In anderen Worten ausgedrückt kann die Erfindung somit als ein Computerprogramm mit einem Programmcode zur Durchführung des Verfahrens realisiert werden, wenn das Computerprogramm auf einem Computer und/oder Mikrocontroller abläuft.

In Ausführungsbeispielen kann der Magnetfeldsensor ausgebildet sein, um die den Betriebsphasen zugeordneten Messsignale durch eine erste Linearkombination zu einem ersten Gesamtmesswert zu kombinieren, so dass der Einfluss der Messfeldkomponente in dem ersten gesamten Messwert auf wener als 10%, 1% oder 0,1% des ersten Gesamtmesswertes reduziert ist.

In weiteren Ausführungsbeispielen können die den Betriebsphasen zugeordneten Messsignale durch eine zweite Linearkombination zu einem zweiten Gesamtmesswert kombiniert werden, so dass der Anteil der Kalibrierungsfeldkomponente in dem zweiten Gesamtmesswert auf weniger als 10%, 1% oder 0,1% des zweiten Gesamtmesswertes reduziert ist.

Der Magnetfeldsensor kann in Ausführungsbeispielen die erste (102), zweite (104) und dritte Sensorelementanordnung (106) in einem Spinning-Current-Modus betreiben. In Ausführungsbeipielen des Verfahrens kann der Schritt des ersten linearen Kombinierens der den Betriebsphasen zugeordneten Messsignale einer Magnetfeldkomponente zu einem ersten Gesamtmesswert derart erfolgen, dass ein Anteil der Messfeldkomponente in dem ersten Gesamtmesswert auf weniger als 10%, 1% oder 0,1% des ersten Gesamtmesswertes reduziert wird.

**Patentansprüche**

1. Im Messbetrieb kalibrierbarer Magnetfeldsensor (100) zur Erfassung einer ersten, zweiten und dritten räumlichen Komponente $B_z$, $B_y$ und $B_x$ eines Magnetfeldes in einem Referenzpunkt (101), wobei das Magnetfeld eine erste, zweite und dritte Messfeldkomponente $B_{Mxz}$, $B_{My}$, $B_{Mx}$ und/oder eine erste, zweite und dritte Kalibrierungsfeldkomponente $B_{Kz}$, $B_{Ky}$ und $B_{Kx}$ aufweist, mit folgenden Merkmalen:

einer ersten Sensorelementanordnung (102) zur Erfassung der ersten Magnetfeldkomponente $B_z$, die eine erste Messfeldkomponente $B_{Mz}$ und/oder eine erste Kalibrierungsfeldkomponente $B_{Kz}$ aufweist, bezüglich einer ersten Raumachse z im Referenzpunkt (101);

einer zweiten Sensorelementanordnung (104) zur Erfassung der zweiten Magnetfeldkomponente $B_y$, die eine zweite Messfeldkomponente $B_{My}$ und/oder eine zweite Kalibrierungsfeldkomponente $B_{Ky}$ aufweist, bezüglich einer zweiten Raumachse y im Referenzpunkt (101);

einer dritten Sensorelementanordnung (106) zur Erfassung der dritten Magnetfeldkomponente $B_x$, die eine dritte Messfeldkomponente $B_{Mx}$ und/oder eine dritte Kalibrierungsfeldkomponente $B_{Kx}$ aufweist, bezüglich einer dritten Raumachse x im Referenzpunkt (101); und

einer Erregerleitung (108), die so bezüglich der ersten (102), zweiten (104) und dritten Sensorelementanordnung (106) angeordnet ist, dass bei einer Einprägung eines vorgegebenen Stroms in die Erregerleitung (108) eine erste vorgegebene Kalibrierungsfeldkomponente $B_{Kz}$ bezüglich der ersten Raumachse z in der ersten Sensorelementanordnung (102) erzeugt wird, eine zweite vorgegebene Kalibrierungsfeldkomponente $B_{Ky}$ bezüglich der zweiten Raumachse y in der zweiten Sensorelementanordnung (104) erzeugt wird und eine dritte vorgegebene Kalibrierungsfeldkomponente $B_{Kx}$ bezüglich der dritten Raumachse x in der dritten Sensorelementanordnung (106) erzeugt wird, wobei die drei Raumachsen z, y und x entlang linear unabhängiger Ortsvektoren verlaufen.

2. Magnetfeldsensor gemäß Anspruch 1, bei dem die erste (102), zweite (104) und dritte Sensorelementanordnung (106) in einer Mehrzahl von Betriebsphasen betreibbar sind, wobei jede der ersten (102), zweiten (104) und dritten Sensorelementanordnungen (106) ausgebildet ist, um in jeder Betriebsphase ein der Betriebsphase zuordenbares Messsignal bereitzustellen.

3. Magnetfeldsensor gemäß Anspruch 2, wobei jede der ersten (102), zweiten (104) und dritten Sensorelementanordnung (106) ausgebildet ist, um die den Betriebsphasen zugeordneten Messsignale bereitzustellen, wobei die den Betriebsphasen zugeordneten Messsignale durch eine erste Linearkombination zu einem ersten Gesamtmesswert kombinierbar sind, so dass der Einfluss der Messfeldkomponente in dem ersten gesamten Messwert reduziert ist, oder die den Betriebsphasen zugeordneten Messsignale durch eine zweite Linearkombination zu einem zweiten Gesamtmesswert kombinierbar sind, so dass der Einfluss der Kalibrierungsfeldkomponente in dem zweiten Gesamtmesswert reduziert ist.

4. Magnetfeldsensor gemäß einem der Ansprüche 1 bis 3, wobei die erste Sensorelementanordnung (102) ein bezüglich einer Hauptoberfläche des Magnetfeldsensors horizontales Hall-Sensorelement aufweist.

5. Magnetfeldsensor gemäß einem der Ansprüche 1 bis 4, wobei die erste Sensorelementanordnung (102) eine Mehrzahl von bezüglich einer Hauptoberfläche des Magnetfeldsensors horizontalen Hall-Sensorelementen aufweist, wobei die geometrische Anordnung der Mehrzahl von horizontalen Hall-Sensorelementen bezüglich des Referenzpunktes (101) paarweise symmetrisch ist und die Hall-Sensorelemente derart miteinander gekoppelt sind, dass die Magnetfeldkomponente offset-kompensiert erfassbar ist.

6. Magnetfeldsensor gemäß einem der Ansprüche 1 bis 5, wobei die zweite Sensorelementanordnung (104) zumindest zwei bezüglich einer Hauptoberfläche des Magnetfeldsensors vertikale Hall-Sensorelemente aufweist, wobei die geometrische Anordnung der mindestens zwei vertikalen Hall-Sensorelemente bezüglich des Referenzpunktes (101) paarweise symmetrisch ist, und die derart miteinander gekoppelt sind, dass die Magnetfeld-komponente offset-kompensiert erfassbar ist.

7. Magnetfeldsensor gemäß einem der Ansprüche 1 bis 6, wobei die dritte Sensorelementanordnung (106) zumindest zwei bezüglich einer Hauptoberfläche des Magnetfeldsensors vertikale Hall-Sensorelemente aufweist, wobei die geometrische Anordnung der mindestens zwei vertikalen Hall-Sensorelemente bezüglich des Referenzpunktes (101) paarweise symmetrisch ist, und die derart miteinander gekoppelt sind, dass die Magnetfeld-komponente offset-kompensiert erfassbar ist.

8. Verfahren zum Kalibrieren eines Magnetfeldsensors im Messbetrieb mittels Erfassung einer ersten, zweiten und dritten räumlichen Komponente $B_z$, $B_y$ und $B_x$ eines Magnetfeldes in einem Referenzpunkt (101), wobei das Ma-

**EP 2 049 910 B1**

gnetfeld eine erste, zweite und dritte Messfeldkomponente $B_{Mz}$, $B_{My}$, $B_{Mx}$ und/oder eine erste, zweite und dritte Kalibrierungsfeldkomponente $B_{Kz}$, $B_{Ky}$ und $B_{Kx}$ aufweist, mit folgenden Schritten:

Erfassen der ersten Magnetfeldkomponente $B_z$, die eine erste Messfeldkomponente $B_{Mz}$ und/oder eine erste Kalibrierungsfeldkomponente $B_{Kz}$ aufweist, bezüglich der ersten Raumachse z im Referenzpunkt;
Erfassen der zweiten Magnetfeldkomponente $B_y$, die eine zweite Messfeldkomponente $B_{My}$ und/oder eine zweite Kalibrierungsfeldkomponente $B_{Ky}$ aufweist, bezüglich der zweiten Raumachse y im Referenzpunkt;
Erfassen der dritten Magnetfeldkomponente $B_x$, die eine dritte Messfeldkomponente $B_{Mx}$ und/oder eine dritte Kalibrierungsfeldkomponente $B_{Kx}$ aufweist, bezüglich der dritten Raumachse x im Referenzpunkt; und
Erzeugen der ersten, zweiten und dritten Kalibrierungsfeldkomponente $B_{Kz}$ $B_{Ky}$ und $B_{Kx}$ bezüglich der ersten, zweiten und dritten Raumachse z, y und x, wobei die erste, zweite und dritte Raumachse entlang linear unabhängiger Ortsvektoren verlaufen.

9. Verfahren gemäß Anspruch 8, bei dem die Schritte des Erfassens während einer Mehrzahl von Betriebsphasen wiederholt werden, wobei die der ersten Magnetfeldkomponente $B_z$, die der zweiten Magnetfeldkomponente $B_y$, und die der dritten Magnetfeldkomponente $B_x$ in den Betriebsphasen zugeordneten Messsignale erfasst werden.

10. Verfahren gemäß den Ansprüchen 8 oder 9, das ferner einen Schritt eines ersten linearen Kombinierens der den Betriebsphasen zugeordneten Messsignale einer Magnetfeldkomponente zu einem ersten Gesamtmesswert aufweist, so dass der Einfluss der Messfeldkomponente in dem ersten Gesamtmesswert reduziert ist, oder einen Schritt eines zweiten linearen Kombinierens der den Betriebsphasen zugeordneten Messsignale einer Magnetfeldkomponente zu einem zweiten Gesamtmesswert aufweist, so dass der Einfluss der Messfeldkomponente in dem zweiten gesamten Messwert reduziert ist.

11. Verfahren gemäß Anspruch 10, bei dem der Schritt des zweiten Kombinierens der den Betriebsphasen zugeordneten Messsignale einer Magnetfeldkomponente zu einem zweiten Gesamtmesswert derart erfolgt, dass der Anteil der Kalibrierungsfeldkomponente in dem zweiten Gesamtmesswert auf weniger als 10%, 1% oder 0,1% des zweiten Gesamtmesswertes reduziert ist.

12. Verfahren gemäß einem der Ansprüche 8 bis 11, das ferner einen Schritt des Kombinierens der den Betriebsphasen zugeordneten Messsignale einer Magnetfeldkomponente umfasst, so dass die Magnetfeldkomponente offset-kompensiert erfassbar ist.

13. Verfahren gemäß einem der Ansprüche 8 bis 12, bei dem die Betriebsphasen gemäß einem Spinning-Current-Verfahren ausgestaltet sind.

14. Verfahren gemäß einem der Ansprüche 8 bis 13, ferner mit folgenden Schritten:

Speichern von Erregerstromstärken, Messfeldkomponenten oder Kalibrierungsfeldkomponenten zur Kalibrierung;
Zuordnen der Erregerstromstärken zu Kalibrierungsfeldkomponenten bzw. Magnetfeldstärken; und
Bereitstellen von Wertepaaren vom Messfeldkomponenten und Magnetfeldstärken.

15. Computerprogramm mit einem Programmcode zur Durchführung aller Schritte des Verfahrens nach Anspruch 8, wenn der Programmcode auf einem Computer abläuft.

**Claims**

1. A magnetic field sensor (100) calibratable during measurement operation for detecting first, second, and third spatial components $B_z$, $B_y$ and $B_x$ of a magnetic field at a reference point (101), wherein the magnetic field has first, second, and third measurement field components $B_{Mz}$, $B_{My}$ and $B_{Mx}$, and/or first, second, and third calibration field components $B_{Kz}$, $B_{Ky}$ and $B_{Kx}$, comprising:

a first sensor element arrangement (102) for detecting the first magnetic field component $B_z$ having a first measurement field component $B_{Mz}$ and/or a first calibration field component $B_y$, with respect to a first spatial axis z at the reference point (101);
a second sensor element arrangement (104) for detecting the second magnetic field component $B_y$ having a second measurement field component $B_{My}$ and/or a second calibration field component $B_{Ky}$, with respect to a second spatial axis y at the reference point (101);

a third sensor element arrangement (106) for detecting the third magnetic field component $B_x$ having a third measurement field component $B_{Mx}$ and/or a third calibration field component $B_{Kx}$, with respect to a third spatial axis x at the reference point (101); and

an excitation line (108) arranged such with respect to the first (102), second (104), and third sensor element arrangements (106) that when impressing a predetermined current into the excitation line (108), a first predetermined calibration field component $B_{Kz}$ with respect to the first spatial axis z in the first sensor element arrangement (102) is generated, a second predetermined calibration field component $B_{Ky}$ with respect to the second spatial axis y in the second sensor element arrangement (104) is generated, and a third predetermined calibration field component $B_{Kx}$ with respect to the third spatial axis x in the third sensor element arrangement (106) is generated, wherein the three spatial axes z, y, and x run along linearly independent position vectors.

2. The magnetic field sensor according to claim 1, wherein the first (102), second (104) and third sensor element arrangements (106) can be operated in a plurality of operating phases, wherein each of the first (102), second (104), and third sensor element arrangements (106) is implemented to provide, in every operating phase, a measurement signal attributable to the operating phase.

3. The magnetic field sensor according to claim 2, wherein each of the first (102), second (104) and third sensor element arrangements (106) is implemented to provide the measurement signals attributed to the operating phases, wherein the measurement signals attributed to the operating phases can be combined to a first total measurement value by a first linear combination, such that the influence of the measurement field component in the first total measurement value is reduced, or the measurement signals attributed to the operating phases can be combined to a second total measurement value by a second linear combination, such that the influence of the calibration field component in the second total measurement value is reduced.

4. The magnetic field sensor according to one of claims 1 to 3, wherein the first sensor element arrangement (102) has a Hall sensor element horizontal with respect to a main surface of the magnetic field sensor.

5. The magnetic field sensor according to one of claims 1 to 4, wherein the first sensor element arrangement (102) has a plurality of Hall sensor elements horizontal with respect to a main surface of the magnetic field sensor, wherein the geometrical arrangement of the plurality of horizontal Hall sensor elements is symmetrical in pairs with respect to the reference point (101) and the Hall sensor elements are coupled to each other such that the magnetic field component can be detected in an offset-compensated manner.

6. The magnetic field sensor according to one of claims 1 to 5, wherein the second sensor element arrangement (104) has at least two Hall sensor elements vertical with respect to a main surface of the magnetic field sensor, wherein the geometrical arrangement of the at least two vertical Hall sensor elements is symmetrical in pairs with respect to the reference point (101), and that are coupled to each other such that the magnetic field component can be detected in an offset-compensated manner.

7. The magnetic field sensor according to one of claims 1 to 6, wherein the third sensor element arrangement (106) has at least two Hall sensor elements vertical with respect to a main surface of the magnetic field sensor, wherein the geometrical arrangement of the at least two vertical Hall sensor elements is symmetrical in pairs with respect to the reference point (101), and that are coupled to each other such that the magnetic field component can be detected in an offset-compensated manner.

8. A method for calibrating a magnetic field sensor during measurement operation by detecting first, second, and third spatial components $B_z$, $B_y$ and $B_x$ of a magnetic field at a reference point (102), wherein the magnetic field has first, second, and third measurement field components $B_{Mz}$, $B_{My}$, $B_{Mx}$ and/or first, second, and third calibration field components $B_{Kz}$, $B_{Ky}$ and $B_{Kx}$, comprising:

detecting the first magnetic field component $B_z$ having a first measurement field component $B_{Mz}$ and/or a first calibration field component $B_{Kz}$ with respect to the first spatial axis z at the reference point;

detecting the second magnetic field component $B_y$ having a second measurement field component $B_{My}$ and/or a second calibration field component $B_{Ky}$ with respect to the second spatial axis y at the reference point;

detecting the third magnetic field component $B_x$ having a third measurement field component $B_{My}$ and/or a third calibration field component $B_{Kx}$ with respect to the third spatial axis x at the reference point; and

generating the first, second, and third calibration field components $B_{Kz}$, $B_{Ky}$ and $B_{Kx}$ with respect to the first, second, and third spatial axes z, y and x, wherein the first, second, and third spatial axes run along linearly independent position vectors.

9. The method according to claim 8, wherein the steps of detecting are repeated during a plurality of operating phases, wherein measurement signals attributed to the first magnetic field component $B_z$, to the second magnetic field component $B_y$, and to the third magnetic field component $B_x$ in the operating phases are detected.

10. The method according to claims 8 or 9, further comprising a step of first linearly combining the measurement signals of a magnetic field component attributed to the operating phases to a first total measurement value, such that the influence of the measurement field component in the first total measurement value is reduced, or a step of second linearly combining the measurement signals of a magnetic field component attributed to the operating phases to a second total measurement value, such that the influence of the measurement field component in the second total measurement value is reduced.

11. The method according to claim 10, wherein the step of second combining the measurement signals of a magnetic field component attributed to the operating phases to a second total measurement value is performed such that the portion of the calibration field component in the second total measurement value is reduced to less than 10%, 1 %, or 0.1 % of the second total measurement value.

12. The method according to one of claims 8 to 11, further comprising a step of combining the measurement signals of a magnetic field component attributed to the operating phases, such that the magnetic field component can be detected in an offset-compensated manner.

13. The method according to one of claims 8 to 12, wherein the operating phases are implemented according to a spinning current method.

14. The method according to one of claims 8 to 13, further comprising:

   storing excitation current strengths, measurement field components, or calibration field components for calibration;
   attributing the excitation current strengths to the calibration field components or magnetic field strengths, respectively; and
   providing value pairs of measurement field components and magnetic field strengths.

15. A computer program having a program code for performing all the steps of the method according to claim 8, when the program code runs on a computer.

**Revendications**

1. Capteur de champ magnétique (100) pouvant être étalonné en fonctionnement de mesure, destiné à capter une première, une deuxième et une troisième composante spatiale $B_z$, $B_y$ et $B_x$ d'un champ magnétique à un point de référence (101), le champ magnétique présentant une première, une deuxième et une troisième composante de champ de mesure $B_{Mz}$, $B_{My}$, $B_{Mx}$, et/ou une première, une deuxième et une troisième composante de champ d'étalonnage $B_{Kz}$, $B_{Ky}$ et $B_{Kx}$, aux caractéristiques suivantes:

   un premier aménagement d'éléments capteurs (102) destiné à capter la première composante de champ magnétique $B_z$ présentant une première composante de champ de mesure $B_{Mz}$ et/ou une première composante de champ d'étalonnage $B_{Kz}$, par rapport à un premier axe spatial z au point de référence (101);
   un deuxième aménagement d'éléments capteurs (104) destiné à capter la deuxième composante de champ magnétique $B_y$ présentant une deuxième composante de champ de mesure $B_{My}$ et/ou une deuxième composante de champ d'étalonnage $B_{Ky}$, par rapport à un deuxième axe spatial y au point de référence (101);
   un troisième aménagement d'éléments capteurs (106) destiné à capter la troisième composante de champ magnétique $B_x$ présentant une troisième composante de champ de mesure $B_{Mx}$ et/ou une troisième composante de champ d'étalonnage $B_{Kx}$, par rapport à un troisième axe spatial x au point de référence (101); et
   une ligne d'excitation (108), qui est disposée par rapport au premier (102), au deuxième (104) et au troisième aménagement d'éléments capteurs (106) de sorte que, lorsqu'il est imprimé un courant prédéterminé dans la ligne d'excitation (108), il soit généré une première composante de champ d'étalonnage prédéterminée $B_{Kz}$ par rapport au premier axe spatial z dans le premier aménagement d'éléments capteurs (102), qu'il soit généré une deuxième composante de champ d'étalonnage prédéterminée $B_{Ky}$ par rapport au deuxième axe spatial y dans le deuxième aménagement d'éléments capteurs (104) et qu'il soit généré une troisième composante de champ d'étalonnage prédéterminée $B_{Kx}$ par rapport au troisième axe spatial x dans le troisième aménagement d'éléments capteurs (106), les trois axes spatiaux z, y et x s'étendant le long de vecteurs de lieu linéairement indépendants.

2. Capteur de champ magnétique selon la revendication 1, dans lequel le premier (102), le deuxième (104) et le troisième aménagement d'éléments capteurs (106) peuvent fonctionner dans une pluralité de phases de fonctionnement, chacun des premier (102), deuxième (104) et troisième aménagements d'éléments capteurs (106) étant réalisé de manière à mettre à disposition, dans chaque phase de fonctionnement, un signal de mesure pouvant être associé à la phase de fonctionnement.

3. Capteur de champ magnétique selon la revendication 2, chacun parmi le premier (102), le deuxième (104) et le troisième aménagement d'éléments capteurs (106) étant réalisé de manière à mettre à disposition les signaux de mesure associés aux phases de fonctionnement, les signaux de mesure associés aux phases de fonctionnement pouvant être combinés par une première combinaison linéaire, pour obtenir une première valeur de mesure totale, de sorte que l'influence de la composante de champ de mesure dans la première valeur de mesure totale soit réduite, ou les signaux de mesure associés aux phases de fonctionnement pouvant être combinés par une deuxième combinaison linéaire, pour obtenir une deuxième valeur de mesure totale, de sorte que l'influence de la composante de champ d'étalonnage dans la deuxième valeur de mesure totale soit réduite.

4. Capteur de champ magnétique selon l'une des revendications 1 à 3, le premier aménagement d'éléments capteurs (102) présentant un élément capteur de Hall horizontal par rapport à une surface principale du capteur de champ magnétique.

5. Capteur de champ magnétique selon l'une des revendications 1 à 4, le premier aménagement d'éléments capteurs (102) présentant une pluralité d'éléments capteurs de Hall horizontaux par rapport à une surface principale du capteur de champ magnétique, la disposition géométrique de la pluralité d'éléments capteurs de Hall horizontaux par rapport au point de référence (101) étant symétrique par paire et les éléments capteurs de Hall étant couplés entre eux de sorte que la composante de champ magnétique puisse être captée de manière compensée en décalage.

6. Capteur de champ magnétique selon l'une des revendications 1 à 5, le deuxième aménagement d'éléments capteurs (104) présentant au moins deux éléments capteurs de Hall verticaux par rapport à une surface principale du capteur de champ magnétique, la disposition géométrique des au moins deux éléments capteurs de Hall verticaux par rapport au point de référence (101) étant symétrique par paire, et qui sont couplés entre eux de sorte que la composante de champ magnétique puisse être captée de manière compensée en décalage.

7. Capteur de champ magnétique selon l'une des revendications 1 à 6, le troisième aménagement d'éléments capteurs (106) présentant au moins deux éléments capteurs de Hall verticaux par rapport à une surface principale du capteur de champ magnétique, la disposition géométrique des au moins deux éléments capteurs de Hall verticaux par rapport au point de référence (101) étant symétrique par paire, et qui sont couplés entre eux de sorte que la composante de champ magnétique puisse être captée de manière compensée en décalage.

8. Procédé pour étalonner un capteur de champ magnétique en fonctionnement de mesure en captant une première, une deuxième et une troisième composante spatiale $B_z$, $B_y$ et $B_x$ d'un champ magnétique à un point de référence (101), le champ

magnétique présentant une première, une deuxième et une troisième composante de champ de mesure $B_{Mz}$, $B_{My}$, $B_{Mx}$, et/ou une première, une deuxième et une troisième composante de champ d'étalonnage $B_{Kz}$, $B_{Ky}$ et $B_{Kx}$, aux étapes suivantes consistant à:
capter la première composante de champ magnétique $B_z$ présentant une première composante de champ de mesure $B_{Mz}$ et/ou une première composante de champ d'étalonnage $B_{Kz}$, par rapport au premier axe spatial z au point de référence;
capter la deuxième composante de champ magnétique $B_y$ présentant une deuxième composante de champ de mesure $B_{My}$ et/ou une deuxième composante de champ d'étalonnage $B_{Ky}$, par rapport au deuxième axe spatial y au point de référence;

capter la troisième composante de champ magnétique $B_x$ présentant une troisième composante de champ de mesure $B_{Mx}$ et/ou une troisième composante de champ d'étalonnage $B_{Kx}$, par rapport au troisième axe spatial x au point de référence; et

générer la première, la deuxième et la troisième composante de champ d'étalonnage $B_{Kz}$, $B_{Ky}$ et $B_{Kx}$ par rapport au premier, au deuxième et au troisième axe spatial z, y et x, le premier, le deuxième et le troisième axe spatial s'étendant le long de vecteurs de lieu linéairement indépendants.

9.  Procédé selon la revendication 8, dans lequel les étapes consistant à capter sont répétées pendant une pluralité de phases de fonctionnement, les signaux associés à la première composante de champ magnétique $B_z$, les signaux associés à la deuxième composante de champ magnétique $B_y$ et les signaux associés à la troisième composante de champ magnétique $B_x$ dans les phases de fonctionnement étant captés.

10. Procédé selon les revendications 8 ou 9, présentant par ailleurs une étape d'une première combinaison linéaire des signaux de mesure associés aux phases de fonctionnement d'une composante de champ magnétique, pour obtenir une première valeur de mesure totale, de sorte que l'influence de la composante de champ de mesure dans la première valeur de mesure totale soit réduite, ou une étape d'une deuxième combinaison linéaire des signaux de mesure associés aux phases de fonctionnement d'une composante de champ magnétique, pour obtenir une deuxième valeur de mesure totale, de sorte que l'influence de la composante de champ de mesure dans la deuxième valeur de mesure totale soit réduite.

11. Procédé selon la revendication 10, dans lequel l'étape de la deuxième combinaison des signaux de mesure associés aux phases de fonctionnement d'une composante de champ magnétique, pour obtenir une deuxième valeur de mesure totale a lieu de sorte que la part de la composante de champ d'étalonnage dans la deuxième valeur de mesure totale soit réduite à moins de 10%, 1% ou 0,1% de la deuxième valeur de mesure totale.

12. Procédé selon l'une des revendications 8 à 11, comprenant par ailleurs une étape consistant à combiner les signaux de mesure associés aux phases de fonctionnement d'une composante de champ magnétique, de sorte que la composante de champ magnétique puisse être captée de manière compensée en décalage.

13. Procédé selon l'une des revendications 8 à 12, dans lequel les phases de fonctionnement sont réalisées selon un procédé à courant hélicoïdal.

14. Procédé selon l'une des revendications 8 à 13, par ailleurs aux étapes suivantes consistant à:

mémoriser les intensités de courant d'excitation, les composantes de champ de mesure ou les composantes de champ d'étalonnage pour l'étalonnage;
associer les intensités de courant d'excitation aux composantes de champ d'étalonnage ou intensités de champ magnétique; et
mettre à disposition des paires de valeurs de composantes de champ de mesure et d'intensités de champ magnétique.

15. Programme d'ordinateur avec un code de programme pour réaliser toutes les étapes du procédé selon la revendication 8 lorsque le code de programme est exécuté sur un ordinateur.

## FIG 1

## FIG 2

# FIG 3

# FIG 4a I)

Phase 0

Sensor 1

Sensor 2

⊙ B-Feld optional

# FIG 4a II)

# FIG 4b I)

Phase 1

Sensor 1

Sensor 2

# FIG 4b II)

## FIG 4c I)

Phase 2

Sensor 1

Sensor 2

⊙ B-Feld

## FIG 4c II)

## FIG 4d I)

Phase 3

Sensor 1

—104ab—

Sensor 2

⊙ B-Feld

—104cd—

## FIG 4d II)

# FIG 5

# FIG 6

Erregung in negative Y-Richtung

106cd

Spinning-Current tauglicher Sensor

3-Pin Sensor

106c

Erregung in negative X-Richtung

106d

106a

Erregung in positiver X-Richtung

106b

Schnitt

108

Erregung in positiver Y-Richtung

EP 2 049 910 B1

**FIG 7**

**FIG 8**

28

# FIG 9a
(Stand der Technik)

# FIG 9b
(Stand der Technik)

# FIG 10
(Stand der Technik)

Einzelsensor

Sensor
Besteht aus 4
3-Pinnern

Mittelpunkte

1002

1006

1004

Y

Z ⊗ → X

# FIG 11
(Stand der Technik)

1104b  1106b  1104c  1100

1106a

1106c

1004d

1102

1104a  1106d

z
y
x

1110

1112a  1114a

a

d  b

c

1112b  1114b

1112c  1114c

1112d

v_x

v_y

v_z

# FIG 12

### (Stand der Technik)

3 getrennte
Sensoren

Pixelzelle

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10150955
- DE 10150950
- DE 19943128
- EP 1637898 A1

**In der Beschreibung aufgeführte Nicht-Patentliteratur**

- **R. S. Popovic.** Hall Effect Devices, Magnetic Sensors and Characterization of Semiconductors. Adam Hilger, 1991
- **Janez Trontelj.** Optimization of Integrated Magnetic Sensor by Mixed Signal Processing. *Proceedings of the 16th IEEE,* vol. 1
- **C. Schott ; R. S. Popovic.** Integrated 3D Hall Magnetic Field Sensor. *Transducers '99,* 07. Juni 1999, vol. 1, 168-171
- **Enrico Schurig.** Highly Sensitive Vertical Hall Sensors in CMOS Technology. Hartung-Gorre Verlag Konstanz, 2005